# FASCICULE DE BREVET EUROPEEN

(11) **EP 4 081 810 B1**
(45) Date de publication et mention de la délivrance du brevet: **30.04.2025**
(21) Numéro de dépôt: 20851409.1
(22) Date de dépôt: 22.12.2020
(51) Int. Cl.: G01R 15/06, G01R 15/16, H02H 1/00, H02H 3/42

(54) **ORGANE DE MESURE D'UNE TENSION DE MODE COMMUN DANS UN RESEAU ELECTRIQUE ET DISPOSITIF DE DETECTION D'UNE DEFAILLANCE METTANT EN OEUVRE UN TEL ORGANE**
ELEMENT ZUR MESSUNG EINER GLEICHTAKTSPANNUNG IN EINEM ELEKTRISCHEN NETZWERK UND VORRICHTUNG ZUR FEHLERERKENNUNG MIT EINEM SOLCHEN ELEMENT
ELEMENT FOR MEASURING A COMMON MODE VOLTAGE IN AN ELECTRICAL NETWORK AND DEVICE FOR DETECTING A FAULT USING SUCH A ELEMENT

(30) Priorité: 24.12.2019 FR 1915522; 24.12.2019 FR 1915523
(43) Date de publication de la demande: 02.11.2022
(73) Titulaire: Safran Electrical & Power, 31702 Blagnac (FR); CIMA, Lionel, 37540 Saint-Cyr-sur-Loire (FR)
(72) Inventeur: CIMA, Lionel, 37540 Saint-Cyr-sur-Loire (FR)
(74) Mandataire: Gevers & Orès
(86) Numéro de dépôt international: PCT/FR2020/052601
(87) Numéro de publication internationale: WO 2021/130448

(56) Documents cités:
- DE-A1- 10 056 988
- GB-A- 2 007 048
- US-A- 4 763 068
- US-A1- 2012 123 708

## Description

### DOMAINE DE L'INVENTION

La présente invention concerne un dispositif et une méthode de détection d'une défaillance dans un réseau de distribution d'énergie électrique. Elle concerne également un réseau de distribution d'énergie électrique ou bien un équipement équipé d'un tel dispositif de détection.

### ARRIERE PLAN TECHNOLOGIQUE DE L'INVENTION

L'état de la technique comprend notamment les documents US-A-4 736 068, GB-A-2 007 048, US-A1-2012/123708 et DE-A1-100 56 988.

Les besoins de réduction de l'empreinte carbone de l'activité humaine, ainsi que les besoins d'optimisation de l'efficacité énergétique conduisent à favoriser l'emploi de l'énergie électrique. Cet emploi nécessite de transporter de l'énergie électrique, sous une forme continue (DC) ou alternative (AC), entre une ou plusieurs sources (une batterie, une génératrice, des panneaux photovoltaïques par exemple) et une ou plusieurs charges (moteurs électriques, onduleurs...) par l'intermédiaire de lignes de distribution, de système de protection (disjoncteur, sectionneur, et autres organes de coupure). L'ensemble constitué des sources, des charges, des lignes et des systèmes de protection constitue le réseau électrique.

Le réseau est parfois amené à transporter des puissances importantes qui peuvent dépasser plusieurs dizaines de kilowatts, voire des centaines de kilowatts, ou encore des mégawatts. Il peut être embarqué dans un véhicule tel qu'un véhicule terrestre (automobile ou char) ou ferroviaire, un navire de surface ou un sous-marin ou un aéronef par exemple. Il est donc susceptible d'opérer dans un environnement sévère, c'est-à-dire pouvant présenter de grandes amplitudes de température, de pression, de vibration, de champs électromagnétiques ou d'humidité. Une défaillance du réseau dans ces applications peut avoir des conséquences graves, si bien qu'il est impératif de le sécuriser.

D'une manière plus générale, et indépendamment du domaine d'utilisation, il est important de pouvoir détecter, et avantageusement de localiser, une défaillance survenant dans un réseau électrique. Un réseau est généralement protégé par l'intermédiaire de dispositifs de protection, la détection d'une défaillance conduisant à faire basculer ces dispositifs pour isoler électriquement une partie au moins du réseau. Il peut s'agir par exemple de disjoncteurs, de contacteurs, d'interrupteurs à semi-conducteurs (« solid state » selon l'expression anglo-saxonne consacrée), de fusibles ou de limiteurs de courant qui s'enclenchent à l'apparition de courants excessifs. La localisation d'une défaillance permet d'isoler uniquement la section défaillante du réseau, et cette fonctionnalité est avantageuse en ce qu'elle permet de maintenir un niveau de fonctionnement minimum du réseau ainsi qu'une intervention ciblée d'une équipe de maintenance.

Les défaillances pouvant se produire dans un réseau électrique sont de natures variées : défauts d'isolation, pertes par commutation excessive au niveau d'une charge, consommations excessives d'énergie, court-circuit.... Il peut s'agir également de la formation d'un arc électrique dans, ou entre, les conducteurs entrant dans la constitution des lignes de distribution et des appareillages électriques. Un arc électrique correspond à une décharge non intentionnelle se propageant dans un gaz (l'air) entre deux portions conductrices du réseau. Lorsqu'une telle décharge se produit dans un isolant électrique enrobant un conducteur sans l'endommager complètement, on parle alors de « décharge partielle ». Ces décharges électriques peuvent être provoquées par de multiples causes, comme une mauvaise connexion des conducteurs, la dégradation de l'isolant électrique entourant ces conducteurs, la présence de corps étrangers ou la mauvaise qualité d'un isolant. Ils forment des phénomènes fréquents dans les réseaux et sont susceptibles de provoquer des incendies, des explosions, des élévations de températures locales phénoménales, supérieures à 10 000°C, des surpressions élevées et l'émission de rayonnements ultraviolets importants. L'apparition de ces arcs électriques est favorisée par l'humidité, la dépression et la température de l'environnement si bien que leur détection précoce est particulièrement essentielle lorsque le réseau opère dans un environnement sévère tel que cela a été évoqué précédemment.

Les arcs électriques ne sont généralement pas détectés suffisamment précocement par les dispositifs de protection usuels, du type disjoncteur, qui se déclenchent sur la base d'un courant ou d'une puissance consommée excessive. Certains arcs électriques se développent en effet sur des temps très longs, ne provoquant pas l'apparition de surcourant ou de surpuissance dans le réseau qui puisse permettre leurs détections anticipées par les moyens usuels. C'est notamment le cas des arcs « séries » qui peuvent se développer dans un conducteur de puissance ou dans un connecteur. La puissance dissipée au démarrage d'un arc série est nettement inférieure à celle d'un arc parallèle ou à la puissance nominale du réseau.

La détection des arcs électriques dans un réseau est généralement réalisée en surveillant l'évolution temporelle et/ou fréquentielle des signaux du réseau (courant et/ou tension), sachant que la survenance d'un tel phénomène conduit à la formation de signaux présentant un fort contenu spectral, même dans le cas d'un réseau continu. Un exemple d'une telle solution de détection est notamment présenté dans le document US10078105. Ces méthodes fondées sur l'analyse temporelle ou spectrale des signaux, courant et/ou tension, sont toutefois particulièrement difficiles à mettre en œuvre et conduisent à déclencher de nombreux faux-positifs, qui peuvent être provoqués par les charges ou les sources actives (c'est-à-dire commutées) présentes sur le réseau. En particulier, elles ne sont pas performantes pour repérer l'occurrence d'un arc électrique série dans un réseau continu (DC).

### OBJET DE L'INVENTION

Un but de l'invention est de remédier aux inconvénients précités. Un but de l'invention est notamment de proposer un dispositif et une méthode de détection des défaillances d'un réseau électrique qui soient particulièrement fiables et qui soient aptes à détecter l'occurrence, et avantageusement à localiser, une grande variété de défaillances, dont les arcs électriques et en particulier les arcs séries notamment dans un réseau continu.

### BREVE DESCRIPTION DE L'INVENTION

En vue de la réalisation de ce but, l'objet de l'invention propose un organe de mesure d'une grandeur représentative d'une tension de mode commun dans un réseau électrique ou dans un équipement, le réseau ou l'équipement comprenant au moins un premier conducteur de puissance et un deuxième conducteur de puissance, l'organe de mesure comprenant deux éléments capacitifs destinés à être disposés en pont entre les deux conducteurs de puissance et présentant des valeurs de capacité identiques entre elles, les deux éléments capacitifs étant reliés en un point milieu. L'organe de mesure comprend également un dipôle de mesure relié d'une part au point milieu et d'autre part à une borne de connexion destinée à être électriquement reliée à un conducteur commun dont on a équipé le réseau électrique ou l'équipement.

Selon d'autres caractéristiques avantageuses et non limitatives de l'invention, prises seules ou selon toute combinaison techniquement réalisable :
- le dipôle de mesure présente une impédance inférieure à 1kOhms, le dipôle étant apte à développer une tension proportionnelle à la dérivée par rapport au temps d'une tension de mode commun présente entre les deux conducteurs de puissance ;
- le dipôle de mesure présente une impédance supérieure à 1kOhms, le dipôle développant une tension proportionnelle à une tension de mode commun présente entre les deux conducteurs de puissance ;
- les éléments capacitifs sont formés d'un condensateur à trois terminaux, un premier terminal étant destiné à être électriquement relié à l'un des conducteurs de puissance, un deuxième terminal étant destiné à être électriquement relié à l'autre des conducteurs de puissance et le troisième terminal étant destiné à être relié au conducteur commun ;
- le condensateur à trois terminaux est réalisé à partir de seulement 3 électrodes ;
- le condensateur à trois terminaux est réalisé avec des feuilles empilées puis enroulées pour constituer un cylindre ou un parallélépipède à 3 terminaux ;
- l'organe de mesure comprend de plus une résistance à trois électrodes présentant un point milieu, la première électrode étant destinée à être électriquement reliée au premier conducteur de puissance, la seconde électrode étant destinée à être électriquement reliée au deuxième conducteur de puissance, la tension de mode commun étant présente entre le point milieu de la résistance à trois électrodes et le conducteur commun.
- l'organe de mesure comprend un capteur de courant, apte à mesurer le courant de mode différentiel circulant dans les deux éléments capacitifs, pour établir une grandeur représentative de la tension de mode commun, et formé de au moins quatre bobines à air respectivement disposées à proximité des éléments capacitifs ;
- l'organe de mesure comporte en outre un capteur de courant, apte à mesurer le courant de mode commun circulant dans les deux éléments capacitifs pour établir une grandeur représentative d'une tension de mode différentiel ;
- le capteur de courant apte à mesurer le courant de mode commun est formé de au moins deux bobines à air respectivement disposées à proximité des éléments capacitifs ;
- l'organe de mesure comprend en outre un capteur de la composante continue de la tension de mode commun (Vᵣₑₛ) ;
- l'organe de mesure comprend en outre un capteur de la composante continue de la tension de mode différentiel.

Selon un autre aspect, l'invention propose un dispositif de détection d'une défaillance dans un réseau électrique, le réseau électrique comprenant au moins un équipement électrique électriquement relié à un premier conducteur de puissance et à un deuxième conducteur de puissance. Selon l'invention, le réseau étant également muni d'un conducteur commun, le dispositif étant destiné à être relié aux conducteurs de puissance et au conducteur commun au niveau d'une zone de mesure et comprenant :
- un premier organe de mesure tel que décrit précédemment;
- un deuxième organe de mesure permettant d'élaborer une deuxième grandeur représentative d'un courant de réseau circulant les conducteurs de puissance ;
- un calculateur, relié au premier et au deuxième organe de mesure, le calculateur étant configuré pour déterminer, sur une période d'observation déterminée, une grandeur représentative d'une énergie dite « mixte » définie comme l'intégrale sur la période d'observation déterminée du produit de la tension de mode commun et du courant de réseau et transportée dans la zone de mesure, la grandeur représentative de l'énergie mixte étant déterminée à partir de la première grandeur et de la deuxième grandeur .

Selon d'autres caractéristiques avantageuses et non limitatives de cet aspect de l'invention, prises seules ou selon toute combinaison techniquement réalisable :
- le deuxième organe de mesure comprend une bobine à air, par exemple de type Rogowski ;
- le deuxième organe de mesure comporte également un capteur de courant continu, par exemple un capteur à Effet Néel^{®}.

### BREVE DESCRIPTION DES FIGURES

D'autres caractéristiques et avantages de l'invention ressortiront de la description détaillée de l'invention qui va suivre en référence aux figures annexées sur lesquelles :
[Fig. 1a]
[Fig. 1b] Les figures 1a et 1b représentent des exemples d'un réseau électrique selon un mode de réalisation de l'invention ;
[Fig. 2] La figure 2 représente l'état du réseau à un instant d'une période d'observation j établi par un dispositif de supervision ;
[Fig. 3] La figure 3 illustre une section d'un réseau électrique conforme à l'invention ;
[Fig. 4a]
[Fig. 4b]

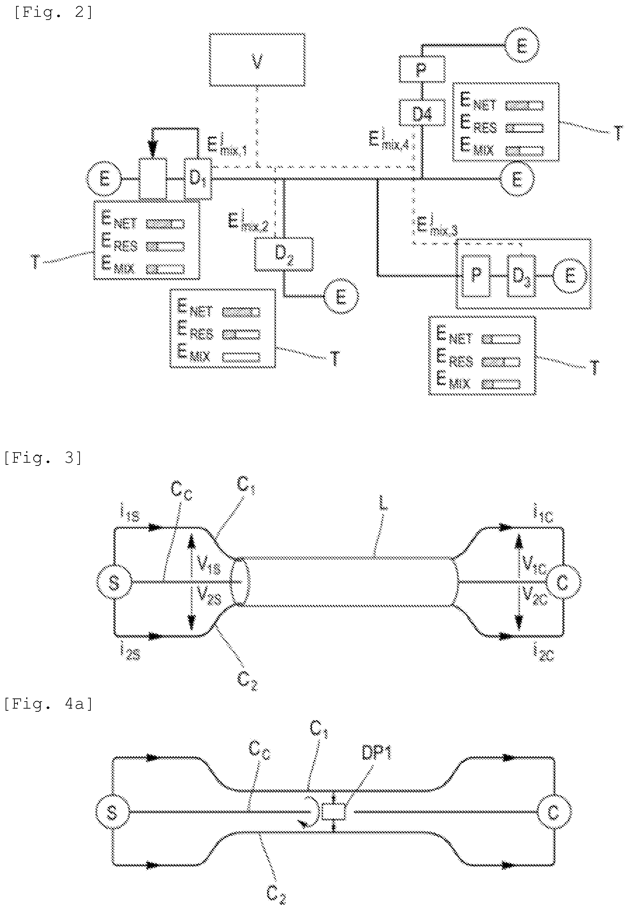

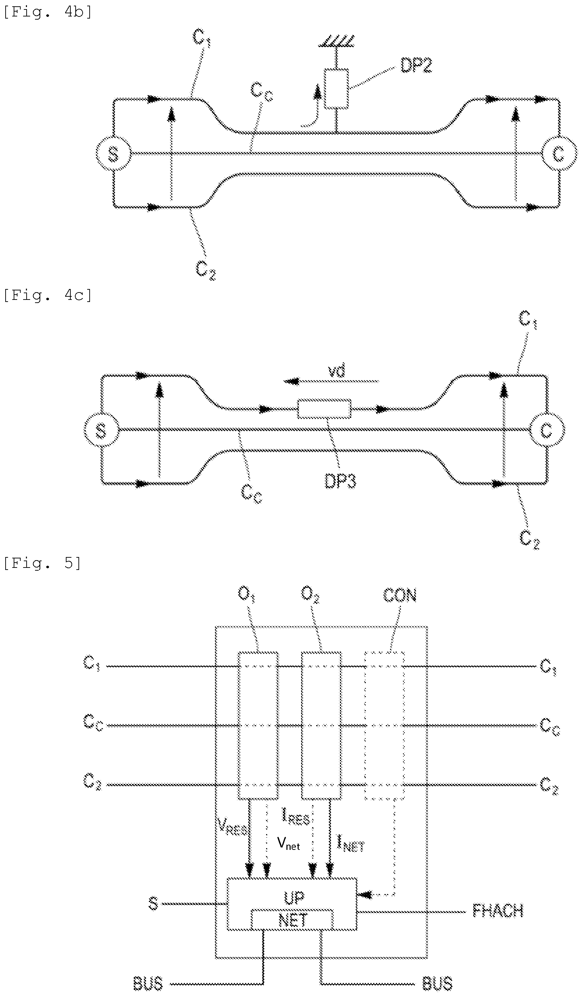

[Fig. 4c] Les figures 4a, 4b et 4c représentent respectivement une section de réseau lors de l'occurrence d'une défaillance de type parallèle, de type défaut d'isolement et de type série ;
[Fig. 5] La figure 5 représente un dispositif de détection conforme à un mode de mise en œuvre de l'invention.

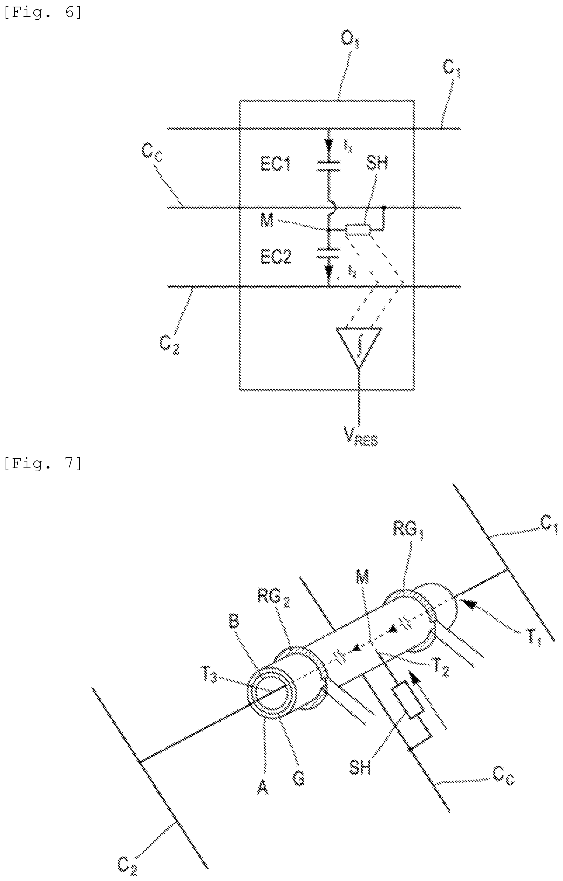

[Fig. 6] La figure 6 représente un circuit schématique formant un autre mode de mise en œuvre d'un premier organe de mesure d'un dispositif de détection.
[Fig. 7] La figure 7 représente un exemple du mode de mise en œuvre d'un premier organe de mesure d'un dispositif de détection ;
[Fig. 8a]
[Fig. 8b]

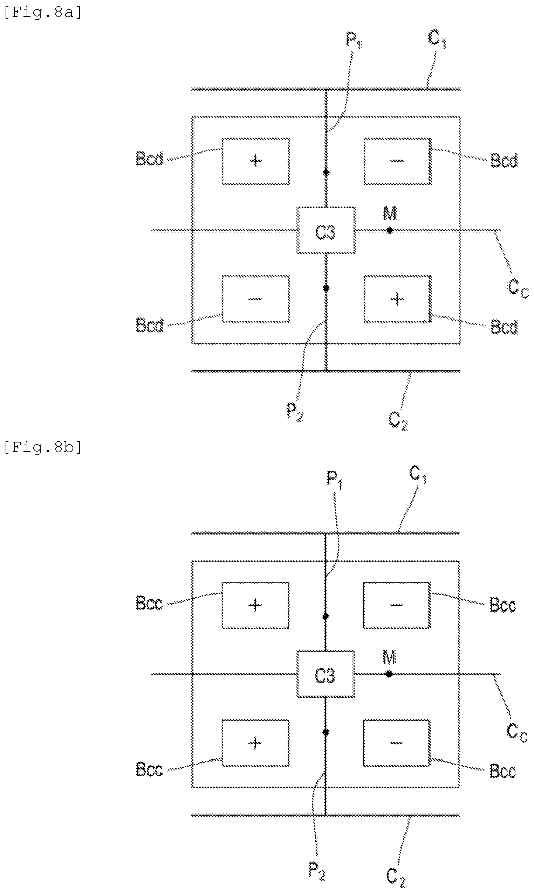

   Les figures 8a et 8b représentent un autre exemple du mode de mise en œuvre d'un premier organe de mesure d'un dispositif de détection ;

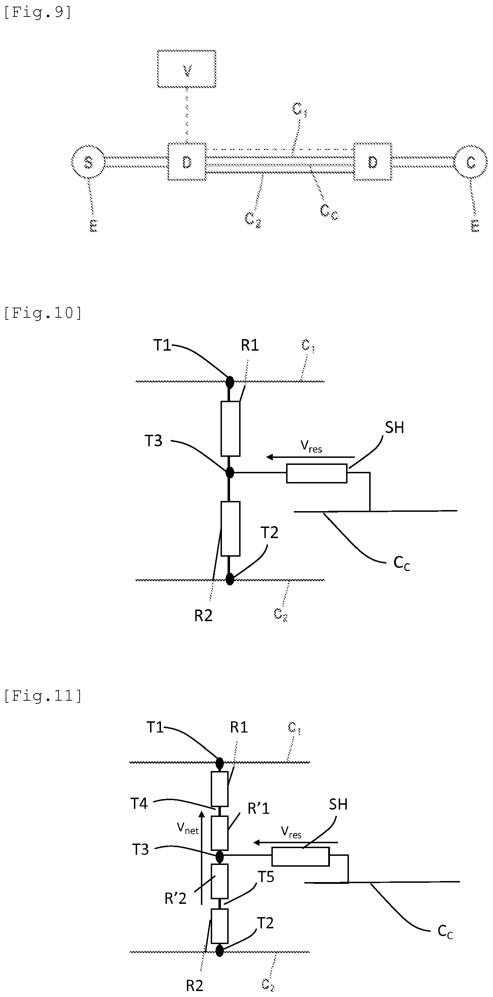

[Fig. 9] La figure 9 représente un système de détection et de localisation d'une défaillance conforme à l'invention.
[Fig. 10]
[Fig. 11]
   Les figures 10 et 11 représentent des exemples de mise en œuvre préférés d'un capteur pour un organe de mesure compatible avec un dispositif de détection de l'invention.

### DESCRIPTION DETAILLEE DE L'INVENTION

Par souci de simplicité d'écriture, on assimilera dans la présente description une grandeur (une énergie, une tension, un courant par exemple) avec la mesure de cette grandeur (la grandeur représentative de l'énergie, de la tension ou du courant mesuré ou estimé).

### Réseau électrique

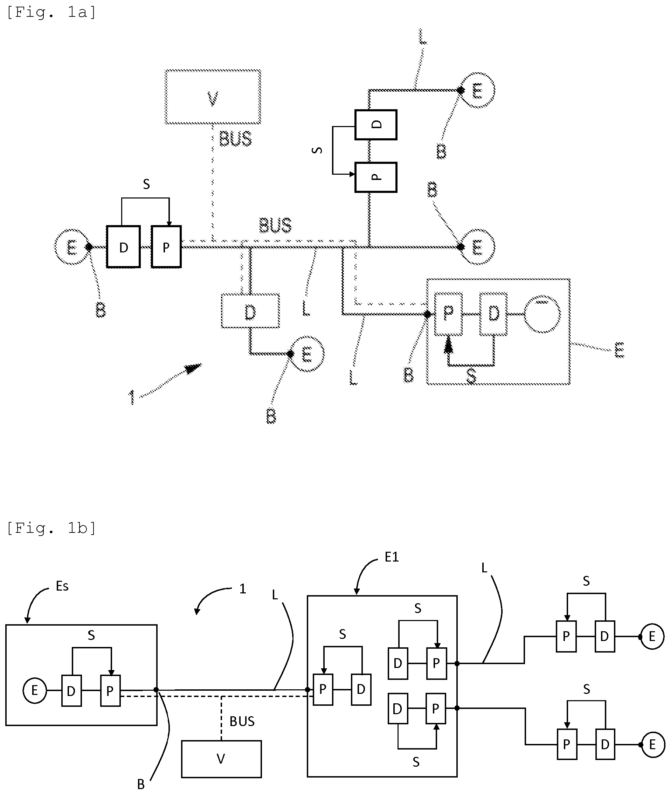

Les figures 1a et 1b représentent deux exemples d'un réseau électrique 1 dont on souhaite surveiller le bon fonctionnement, en détectant l'occurrence de ses défaillances et, avantageusement, en les localisant. Ces défaillances, comme on l'a présenté en introduction de cette demande, peuvent être de natures très diverses, un arc électrique série ou parallèle, une surconsommation, un court-circuit ou tout autre défaut d'isolement.

De manière conventionnelle, ce réseau électrique 1 comprend au moins deux conducteurs de puissance qui permettent de faire transiter la puissance requise. Le réseau électrique 1 peut être un réseau continu (DC), et on considèrera qu'il présente alors une fréquence de réseau comprise entre zéro et 5 Hz pour garder toute sa généralité à la présente description. Il peut s'agir d'un réseau alternatif monophasé conventionnel à fréquence fixe, présentant une fréquence de réseau de 50 Hz ou 60 Hz ou 400 Hz à plus ou moins 5 Hz près, ou d'un réseau alternatif à fréquence variable, typiquement comprise entre 360 et 800 Hz. Mais plus généralement, le réseau électrique 1 peut opérer dans toute gamme de fréquences qui convient. La présente invention s'applique également aux réseaux multiphase, comme un réseau triphasé par exemple.

L'invention s'applique tout particulièrement lorsque le réseau électrique 1 vise à transporter une puissance relativement importante entre les différents équipements électriques, sources ou charges, qui le composent. De préférence donc, les tensions et courants se développant sur le réseau électrique 1 présentent des valeurs typiquement supérieures à, respectivement, 50 V, 330V, 600V, 1000V, 3000V ou 10000V et 100A. Mais rien n'exclut d'appliquer les principes de l'invention à des réseaux électriques transportant des puissances relativement plus réduites.

Comme cela est visible sur la figure 1, le réseau électrique 1 comprend une pluralité d'équipements électriques E (et d'une manière plus générale, au moins un équipement électrique E), sources ou charges, et des lignes conductrices L reliant certains des équipements E entre eux, ici sous la forme d'un réseau maillé, de manière à alimenter électriquement les charges par l'énergie fournie par les sources. Les équipements électriques E sont reliés aux lignes L par l'intermédiaire de bornes de connexion B. Les organes de protection, tels que des disjoncteur, sectionneurs ou tout autre organe de coupure, font partie du réseau 1 et de ses équipements électriques E même s'ils ne sont pas représentés sur les figures.

Les équipements électriques E peuvent être de toute nature qui convient selon le domaine d'application du réseau. Certains de ces équipements E peuvent former alternativement une source et une charge (génératrice/moteur). Il peut d'agir d'un équipement de distribution de puissance. Les équipements peuvent être actifs, tel qu'un onduleur, ou passifs. Les équipements électriques E, lorsqu'ils forment des sources, peuvent être par exemple des batteries ou des génératrices ou des panneaux photovoltaïques ou des éoliennes, etc. Il peut y avoir une combinaison de plusieurs sources et plusieurs charges dans un même réseau. Sur la figure 1b, on a représenté un équipement de distribution E1 disposé au niveau d'un nœud du réseau entre une source Es, et deux charges disposées en bout de lignes L.

Pour permettre la protection du réseau 1, celui-ci est équipé d'un conducteur commun (dont on fera une description plus détaillée dans une section ultérieure de cette description) et il contient au moins un dispositif de détection D et avantageusement une pluralité de tels dispositifs D répartis dans le réseau 1 au niveau d'une pluralité de zones de mesure. Un dispositif de détection D présente des bornes de connexion permettant de le relier aux conducteurs des lignes L ou des équipements E, afin de le placer effectivement dans le réseau. De façon préférentielle, le dispositif de détection D est non intrusif, c'est à dire qu'il est connecté en parallèle des conducteurs de puissance des lignes L et des équipements E formant le réseau 1 (par exemple pour des mesures de tension), ou qu'il met en œuvre des capteurs non intrusifs (par exemple du type bobine à air, à effet Hall ou Effet Néel^{®} pour la mesure de courant). De la sorte on réduit le nombre d'interconnexions sur les conducteurs et ainsi le risque de défaillances de type arc.

L'invention prévoit de distinguer dans toute l'énergie transportée par le réseau, et donc au niveau de chaque zone de mesure, une énergie dite « de réseau » d'une énergie dite « résiduelle » et d'une énergie dite « mixte ». L'énergie de réseau correspond à l'énergie transportée dans une zone de mesure lorsque le réseau est parfaitement équilibré et en l'absence de toute défaillance. L'énergie résiduelle et l'énergie mixte témoignent quant à elles d'un déséquilibre du réseau électrique 1 qui se manifeste et est provoqué à l'occurrence d'une défaillance de réseau. Les énergies résiduelles et mixtes ne sont cependant pas complètement nulles dans un réseau sain, du fait de certains déséquilibres naturels. C'est pour cette raison que selon certains modes de mise en œuvre de l'invention, il est prévu de mesurer des différences point à point ou en des instants distincts entre énergies afin de détecter, et également de localiser, certaines défaillances sans générer de faux-positifs liés aux déséquilibres naturels.

Comme cela sera détaillé dans une partie ultérieure de cette description, un dispositif de détection D conforme à un mode de mise en œuvre de l'invention est apte à mesurer l'énergie de réseau Eₙₑₜ, l'énergie résiduelle Eᵣₑₛ et l'énergie mixte Eₘᵢₓ, transitant au niveau de la zone de mesure du réseau 1 dans lequel il est situé, et pendant des périodes d'observation successives. La mesure de ces énergies permet de détecter et parfois de localiser l'occurrence d'une défaillance dans le réseau 1 ou dans une section du réseau 1. A minima, un tel dispositif de détection D est apte à mesurer une énergie mixte Eₘᵢₓ de manière à permettre la détection d'un arc série. Par souci de clarté, on précise que par « localiser une défaillance », on désigne la faculté d'identifier la section du réseau électrique 1 ou d'identifier l'équipement E dans laquelle la défaillance s'est réalisée. Cette section peut être définie par la partie du réseau comprise entre deux dispositifs de détection D, ou bien par un équipement E de type source disposé en amont d'un dispositif D, ou encore par un équipement E de type charge disposé en aval d'un dispositif de détection D..

Le réseau électrique 1 peut également comprendre un dispositif de protection P, ou une pluralité de tels dispositifs P, permettant d'isoler une section du réseau 1, telle qu'une ligne L ou un équipement électrique E. Il peut s'agir de disjoncteurs conventionnels par exemple. En général, de tels dispositifs P sont placés soit au niveau d'une source, soit au niveau d'une charge, soit, le plus souvent, au niveau des nœuds du réseau via des équipements de distribution E1, comme cela est représenté sur la figure 1b.

Les dispositifs de détection D et les dispositifs de protection P peuvent être répartis très librement dans le réseau 1, selon sa nature et sa topologie en vue d'en assurer sa protection. Ces dispositifs D, P peuvent être placés l'un et/ou l'autre à l'extrémité d'une ligne L, sur une section de ligne L ou intégré à un équipement électrique E. Un dispositif de détection D et de protection P ne sont pas nécessairement associés l'un à l'autre, bien qu'il puisse être avantageux dans certains cas de les associer, par exemple dans un même boîtier, de manière à réaliser un unique module permettant de mettre en œuvre les deux fonctions de détection et de protection. Dans ce cas, une borne de détection du dispositif de détection D, sur lequel un signal S de détection est généré en cas de détection d'une défaillance, peut être relié à une borne de déclenchement du dispositif de protection P.

Certaines sections du réseau 1, lignes L ou équipements E, peuvent ne pas être équipés de dispositifs de détection D et/ou de dispositifs de protection P. Dans ce cas, il peut être impossible de détecter ou localiser l'occurrence d'une défaillance dans cette section de réseau 1 et/ou de déconnecter cette section du réseau 1. Il peut être toutefois possible de détecter l'occurrence de la défaillance à partir d'un dispositif de détection D disposé en dehors de la section d'occurrence de la défaillance et de protéger le réseau 1 dans son ensemble, par exemple en le déconnectant des équipements E formant des sources d'énergie. Pour ce faire, et comme cela sera présenté en détail dans la suite de cet exposé, on pourra mesurer des variations d'énergie directement en sortie d'une source ou directement en entrée d'une charge. Lorsqu'un dispositif de détection D est placé en sortie de source, respectivement en entrée de charge, il est préférable de le mettre le plus en amont possible, et respectivement le plus en aval possible, afin de pouvoir détecter des défauts également dans les dispositifs de protection P ou les bornes de connexion B.

Comme cela sera rendu apparent dans la suite de cette description, certaines catégories de défaillances sont détectables localement, dans une zone de mesure, à partir des seules mesures des énergies de réseau Eₙₑₜ, résiduelle Eᵣₑₛ et/ou mixte Eₘᵢₓ réalisées dans cette zone. C'est notamment le cas d'un arc série, d'un défaut d'isolement ou d'une surconsommation. Le dispositif de détection D est alors apte à générer un signal électrique S, sur une borne de détection de ce dispositif D, indiquant l'occurrence d'une défaillance du réseau 1. Lorsque le dispositif de détection D est associé localement à un dispositif de protection P, ce signal S peut être exploité localement par le dispositif de protection P pour immédiatement isoler la section du réseau défaillante, ligne L ou équipement E, du reste du réseau 1.

Pour détecter d'autres catégories de défaillances, telle que l'occurrence d'un arc électrique entre deux conducteurs parallèles, pour localiser plus précisément des défaillances du réseau 1, ou pour qualifier une défaillance, en termes d'énergie consommée, il peut être parfois nécessaire d'exploiter les mesures d'énergie Eₙₑₜ, Eᵣₑₛ, Eₘᵢₓ fournies par une pluralité de dispositif de détection D. A cet effet, et selon un mode de mise en œuvre particulier de l'invention, on prévoit d'associer au réseau électrique 1 un dispositif de supervision V. Ce dispositif V, typiquement mis en œuvre par un organe de calcul numérique, est relié à certains au moins des dispositifs de détection D du réseau 1 par l'intermédiaire d'un bus de communication BUS, représenté en pointillés sur la figure 1. Tout type de bus peut convenir pour mettre en œuvre le bus de communication BUS, et il peut s'agir notamment d'un bus série ou d'un bus parallèle fonctionnant sous toute forme possible de protocole, qu'il réponde à un standard établi ou non. On note que le dispositif de supervision V peut être intégré à l'un des dispositifs de détection D. Dans ce cas, on peut prévoir que ces dispositifs D comprennent un organe de calcul les rendant apte à mettre en œuvre les traitements de supervision, l'un au moins de ces dispositifs étant alors activé pour opérer comme le dispositif de supervision V du réseau 1.

Dans une configuration dans laquelle le réseau est équipé d'une pluralité de dispositifs de détection D couplés à un dispositif de supervision V, ces dispositifs sont configurés pour placer sur le bus de communication BUS des données indiquant la survenance d'une défaillance et/ou des données représentatives des énergies Eₙₑₜ, Eᵣₑₛ, Eₘᵢₓ dont ils font la mesure sur une période d'observation donnée. Les dispositifs de détection D sont identifiés, sur le réseau informatique formé par le bus de communication BUS, par l'intermédiaire d'un identifiant unique. Le bus de communication BUS comprend une information d'horloge distribuée aux différents dispositifs de détection D de sorte à partager une base de temps commune. Les données E^{j}_{net,i}, E^{j}_{res,i}, E^{j}_{mix,i} représentatives des énergies mesurées par un dispositif d'identifiant i et placées sur le bus de communication BUS lors d'une période d'observation déterminée j peuvent donc être ordonnées et traitées par le dispositif de supervision V pour déterminer l'état du réseau à un instant donné, c'est-à-dire les énergies de réseau, résiduelles, mixtes qui transitent dans chaque zone de mesure pendant une période d'observation donnée.

On a ainsi représenté sur la figure 2, l'état du réseau 1 de la figure 1 à un instant d'une période d'observation j tel qu'il peut être établi par le dispositif de supervision V. Chaque détecteur du réseau D1, D2, D3, D4 est ici identifié par un indice correspondant de manière simplifiée à son identifiant sur le réseau informatique. Chaque détecteur place sur le bus de communication BUS sa mesure d'énergie mixte E^{j}_{mix,i} (et ses autres mesures Eⁱ_{net,i}, E^{j}_{res,i} non représentées sur la figure 2), ce qui permet au dispositif de supervision V de renseigner une structure de donnée de l'état du réseau, symbolisé sur cette figure 2 par des tableaux T des niveaux d'énergie qui transitent dans chaque zone de mesure. Cette structure de donnée peut enregistrer, dans un tableau indexé par la période d'observation j, les énergies de réseau, résiduelle et mixte de chaque zone de mesure. Des dispositifs de détection D (non représentés sur la figure 2) peuvent avantageusement être placés au niveau des « nœuds » de distribution, par exemple dans des équipements de distribution du réseau 1, comme cela a été présenté sur la figure 1b.

Le dispositif de supervision V est configuré pour exploiter les données fournies par les dispositifs de détection D du réseau 1 et remises par le bus de communication BUS. Cette exploitation vise à détecter une défaillance du réseau et/ou à localiser cette défaillance dans le réseau 1 et/ou à qualifier, en termes d'énergie, une défaillance détectée.

Le dispositif de supervision V peut émettre un signal indiquant la défaillance du réseau 1 et ce signal peut être exploité pour déconnecter une section du réseau. A cet effet, le dispositif de supervision V peut être relié à certains au moins des dispositifs de protection P du réseau électrique 1 afin de les activer, le cas échéant. Il peut s'agir d'une liaison point à point ou d'une liaison mettant en œuvre le bus de communication BUS, ou un autre bus dédié, auquel les dispositifs de protection P sont alors reliés. Dans un autre mode de mise en œuvre, le dispositif de supervision, notamment lorsqu'il est intégré dans un des détecteur D du réseau, peut communiquer avec un dispositif tiers responsable du pilotage des dispositifs de protection P du réseau.

On comprend donc que selon le mode de mise en œuvre de l'invention représenté sur les figures 1a et 1b, on dispose d'un réseau électrique 1 et d'une pluralité de dispositifs de détection D répartis sur le réseau 1 au niveau de zones de mesure, ces dispositifs D communiquant à un dispositif de supervision V des données E^{j}_{net,i}, E^{j}_{res,i}, E^{j}_{mix,i} représentatives d'énergies qui transitent dans ces zones de mesure i pendant une période de temps d'observation déterminée j. Le dispositif de supervision V peut exploiter ces données pour représenter l'état du réseau, c'est-à-dire l'énergie qui transite dans chaque zone de mesure pendant des périodes d'observation successives.

Une donnée d'énergie, ou une donnée représentant une variation d'énergie supérieure à un certain seuil permet de détecter une défaillance sans nécessairement être capable de la localiser (sauf au niveau des extrémités du réseau où une variation d'énergie peut permettre de localiser un défaut). En revanche, l'analyse des différences d'énergies qui transitent entre deux (ou plusieurs) dispositifs de détection D permet non seulement d'améliorer la qualité de la détection, mais également de localiser une défaillance entre ces deux dispositifs de détection (D). A cet effet, le dispositif de supervision V peut être configuré pour exploiter les informations fournies par les dispositifs de détection D sur le bus de communication BUS pour localiser une défaillance apparaissant dans le réseau électrique 1 dans la section des conducteurs C1, C2, Cc compris entre ces deux dispositifs ou dans un équipement E du réseau. On dispose ainsi d'un système de localisation d'une défaillance dans le réseau, représenté à titre d'illustration sur la figure 9, en munissant celui-ci d'au moins deux dispositifs de détection D.

Le dispositif de supervision V est donc apte à détecter et/ou localiser et/ou quantifier la survenance d'une défaillance sur le réseau électrique 1 en vue de le protéger, par exemple en déconnectant la section du réseau 1 dans laquelle la défaillance a été localisée.

### Conducteur commun

Pour permettre la distinction des différentes formes d'énergie transportées par le réseau 1 formé des conducteurs de puissance sur lesquels transite l'énergie, l'invention prévoit de munir le réseau 1 d'un conducteur commun. Ce conducteur commun forme une tension de référence pour tous les équipements électriques E du réseau auxquels il est électriquement relié. Il peut s'agir d'une masse mécanique du réseau, ou bien d'un neutre mais cela n'est pas nécessairement le cas. Le conducteur commun n'est pas destiné à faire circuler un courant intense mais il peut se trouver à un potentiel important par rapport à la masse mécanique. Il peut s'agir d'un simple câble de télécommunication, par exemple un câble constituant, en partie au moins, le bus de communication BUS décrit précédemment. Il peut s'agir alternativement d'un conducteur similaire à ceux formant les conducteurs de puissance. Le conducteur commun peut être relié à une borne de connexion de point milieu des équipements E de type « sources » ou « charges » lorsque celles-ci sont symétriques (par exemple deux batteries à point milieu ou le point milieu d'un onduleur ou le point milieu de panneaux photovoltaïques). Le conducteur commun peut être relié à un point milieu existant d'un équipement, source ou charge, ou à un point milieu « fabriqué » à partir d'un diviseur résistif du côté de la source et/ou de la charge. Ce pont diviseur permettant de connecter le conducteur commun peut être intégré dans un dispositif de détection D.

Dans le cas d'une configuration bipolaire (réseau alternatif AC monophasé ou continu DC), une ligne L est donc constituée d'un premier et d'un deuxième conducteur de puissance auquel on ajoute un conducteur commun. Dans le cas d'une configuration triphasée, une ligne L comporte un troisième conducteur de puissance et le commun peut être relié au neutre. Par souci de simplicité, on considèrera dans la suite de cette description que le réseau 1 est un réseau bipolaire comportant donc deux conducteurs de puissance auxquels on ajoute un conducteur commun, mais les principes exposés s'appliquent généralement à un réseau comportant un nombre quelconque de conducteurs de puissance.

### Définition des énergies de réseau, résiduelle et mixte

Pour illustrer le bénéfice qu'apporte le conducteur commun dans le cadre de la détection d'une défaillance dans un réseau électrique, on a représenté sur la figure 3, à titre d'illustration, une section d'un réseau électrique comprenant une ligne L disposée entre une source S et une charge C. La ligne L est ici constituée d'un premier conducteur de puissance C1, d'un deuxième conducteur de puissance C2 et d'un conducteur commun Cc.

Comme cela est bien visible sur ces figures, on définit les courants I₁ₛ, I₂ₛ, I_{1c}, I_{2c} les courants circulant respectivement sur le premier et deuxième conducteur de puissance C1, C2 du côté de la source S et de la charge C. Et on définit de la même manière les tensions V₁ₛ, V₂ₛ, V_{1c}, V_{2c} les différences de potentiel présentes entre le conducteur commun Cc et, respectivement, le premier et deuxième conducteur de puissance C1, C2 du côté de la source S et de la charge C.

On note que les tensions et courants auxquels il sera fait référence dans la suite de cette description sont par nature variables dans le temps, c'est-à-dire qu'ils s'expriment sous la forme V(t) et I(t). Toutefois, pour simplifier l'écriture, on désignera ces courants et tensions variables sous la forme V et I.

En référence à la figure 3, on pose les tensions de réseau du côté de la source et de la charge V_{net,s} V_{net,c} comme les tensions de mode différentiel présentes entre les deux conducteurs de puissance C1, C2 : V_{net,s} = V₁ₛ - V₂ₛ et V_{net,c} = V_{1c} - V_{2c}. Similairement on définit les courants de réseau du côté de la source et de la charge I_{net,s} I_{net,c} comme le courant de mode différentiel circulant sur les deux conducteurs de puissance C1, C2 : I_{net,s} = ½ * (I₁ₛ - I₂ₛ) et I_{net,c} = ½ * (I_{1c} - I_{2c}). Naturellement l'énergie de réseau Eₙₑₜ sur une période d'observation déterminée correspond à l'intégrale, sur cette période, du produit Iₙₑₜ*Vₙₑₜ. Cette énergie de réseau peut être établie du côté de la source E_{net, s} et de la charge E_{net,c}

Lorsque la section du réseau de la figure 3 est en fonctionnement normal et parfaitement équilibrée les tensions de réseau V_{net,s}, V_{net,c} et les courants de réseau I_{net,s}, I_{net,c} de part et d'autre de la ligne L sont identiques entre eux. Les énergies de réseau du côté de la source E_{net,s} et du côté de la charge E_{net,c} sont donc également identiques entre elles aux pertes dissipées dans la ligne près.

La survenance d'une défaillance du réseau électrique conduit à le déséquilibrer, et ce déséquilibre peut être rendu matériel par la mesure des tensions résiduelles V_{res,s}, V_{res,c} qui sont définies du côté de la source par la tension de mode commun V_{res,s} = ½* (V₁ₛ + V₂ₛ) et du côté de la charge par la tension de mode commun V_{res,c} = ½* (V_{1c} + V_{2c}). Similairement, on peut mesurer les courants résiduels I_{res,s} I_{res,c} qui sont définis du côté de la source par les courants de mode commun I_{res,s} = I₁ₛ + I₂ₛ et du côté de la charge par I_{res,c} = I_{1c} + I_{2c}. Naturellement l'énergie résiduelle Eᵣₑₛ sur une période d'observation déterminée correspond à l'intégrale, sur cette période, du produit Iᵣₑₛ*Vᵣₑₛ. Cette énergie résiduelle peut être établie du côté de la source E_{res,s} et de la charge E_{res,c}.

Pour finir, on définit également l'énergie mixte Eₘᵢₓ sur une période d'observation déterminée comme l'intégrale, sur cette période, du produit Iₙₑₜ*Vᵣₑₛ. Cette énergie mixte peut être établie du côté de la source E_{mix,s} et de la charge E_{mix,c}.

Comme on l'a déjà dit, lorsque le réseau de la figure 3 est parfaitement équilibré, les tensions et courants résiduels sont nuls. Les énergies résiduelles et mixtes du côté de la source E_{res,s} E_{mix,s} et du côté de la charge E_{res,c} E_{mix,c} sont également nulles.

### Défaillance de type parallèle entre les conducteurs de puissance (arc parallèle)

En référence à la figure 4a, une défaillance de type parallèle entre les deux conducteurs de puissance C1, C2 de la ligne du réseau représenté sur la figure 3 peut être modélisée comme un dipôle DP1 placé entre ces deux conducteurs C1, C2. La différence des tensions de réseau du côté de la source V_{net,s} et de la charge V_{net,c} n'est pas affectée par la présence de ce dipôle, mais la circulation d'un courant dans le dipôle DP1 entre les conducteurs de puissance C1, C2 conduit à déséquilibrer les courants de réseau I_{net,s} I_{net,c} de part et d'autre de la ligne qui ne sont plus identiques.

A l'occurrence d'une telle défaillance de type parallèle entre les deux conducteurs de puissance C1, C2, il n'y a pas d'apparition de courant résiduel ni de tension résiduelle.

Une défaillance de type parallèle entre les deux conducteurs de puissance C1 C2, comme un arc parallèle, se manifeste comme une différence des courants I_{net,s} I_{net,c} et/ou des énergies de réseau E_{net,s} E_{net,c} sur la période d'observation déterminée, de part et d'autre de la ligne. On note que dans le cas d'un tel arc parallèle, l'énergie dissipée dans le dipôle DP1 qui le modélise est bien supérieure à la puissance nominale du réseau, si bien que la différence des courants I_{net,s} I_{net,c} et/ou des énergies de réseaux E_{net,s} E_{net,c} apparaissant de part et d'autre de la ligne permet de clairement détecter cette défaillance.

Pratiquement, dans le réseau électrique de la figure 2, l'occurrence, au cours d'une période j, d'une défaillance de type parallèle entre deux conducteurs de puissance C1, C2 reliant deux dispositifs de détection Dᵢ, Dᵢ₊₁ d'identifiant respectif i et i+1 peut être détectée par le dispositif de supervision V, en comparant à une valeur d'énergie de réseau seuil S_{i,i+1} la différence des énergies de réseau E^{j}_{net,i} E^{j}_{net,i+1}, fournies respectivement par l'intermédiaire du bus de communication BUS par les dispositifs de détection Dᵢ, Dᵢ₊₁. On peut également utiliser une différence entre les courants I^{j}_{net,i} et I^{j}_{net,i+1} fournies respectivement par l'intermédiaire du bus de communication BUS par les dispositifs de détection Dᵢ, Dᵢ₊₁ pour détecter et localiser un défaut de type parallèle. On peut prévoir que le dispositif de supervision V soit configuré pour exécuter d'autres types de traitement sur les énergies de réseau fournies pour détecter l'occurrence d'une défaillance de ce type. Il peut par exemple s'agir de sommer les énergies fournies au cours de plusieurs périodes successives d'observation avant de procéder à la différence et à la comparaison avec le seuil, afin d'étendre cette période d'observation. Cela permet d'adapter les temps de déclenchement en fonction de la puissance de la défaillance : une défaillance de très forte puissance provoquera une réaction du dispositif de supervision V beaucoup plus rapidement qu'un défaut de puissance moindre. Cela permet également de ne pas déclencher de protection si une défaillance transitoire non persistante apparaît.

D'une manière générale, les seuils de déclenchement S_{i,i+1} associées à deux détecteurs d'indices i, i+1 sont adaptés en fonction de la nature des équipements E du réseau 1 qui peuvent se trouver entre deux dispositifs de détection Dᵢ, Dᵢ₊₁ pour prendre en compte, par exemple, des pertes de lignes ou bien dans des connecteurs, voire la consommation d'un équipement E de nature parallèle et de puissance maximale connue et inférieure à une puissance caractéristique de défaillance.

### Défaillance de type parallèle entre un conducteur de puissance et un élément extérieur (défaut d'isolement).

En référence à la figure 4b, une défaillance de type parallèle entre un des conducteurs de puissance C1, C2 et un élément extérieur au réseau peut être modélisée comme un dipôle DP2 placé entre ce conducteur et cet élément extérieur. L'élément extérieur peut être le conducteur commun Cc, une masse mécanique du réseau, ou tout autre potentiel.

Les tensions de réseau apparaissant du côté de la source V_{net,s} et de la charge V_{net,c} ne sont pas obligatoirement affectées par l'occurrence d'une telle défaillance, cela dépend du schéma de liaison à la terre retenu pour le réseau. Il n'y a quasiment pas d'impact sur les énergies de réseaux, résiduelles et mixtes en cas d'une première défaillance d'un régime dit « IT », i.e. lorsque le réseau est isolé par rapport à la terre ou la masse mécanique. Pour néanmoins identifier l'occurrence de ce type de défaillance dans ce type de réseau, on pourra exploiter un contrôleur permanant d'isolement, comme cela est décrit plus en détail un peu plus loin. En revanche, des différences notables dans les énergies de réseau, résiduelles ou mixtes vont se développer en cas de défaut d'isolement d'un réseau non isolé ou en cas de seconde défaillance d'un réseau isolé.

Un courant circule alors dans le dipôle DP2 entre le conducteur de puissance et l'élément extérieur. En conséquence, le courant circulant du côté de la source S et/ou de la charge C sur ce conducteur de puissance diffère de celui circulant sur l'autre conducteur. Cet écart fait naître un courant résiduel du côté de la source I_{res,s} et/ou du côté de la charge I_{res,c}. Le courant circulant dans le dipôle DP2 développe une différence de potentiel qui affecte également la tension du conducteur de puissance et fait naître une tension résiduelle du côté V_{res,s} de la source ou de la charge V_{res,c}.

En conséquence, l'occurrence d'un défaut d'isolement fait naître, sur une période de temps d'observation déterminée, une énergie résiduelle E_{res,s} ou E_{res,c} d'un côté ou de l'autre de la ligne. En cas de défaut non franc, la variation d'énergie résiduelle sera plus sensible que la variation d'énergie de réseau.

En mesurant, au cours d'une période de temps j, dans une zone de mesure du réseau et à l'aide d'un dispositif de détection D d'identifiant i disposé dans cette zone, l'énergie résiduelle E^{j}_{res,i}, il est donc possible de détecter l'occurrence d'une telle défaillance, par exemple en comparant l'énergie résiduelle mesurée E^{j}_{res,i} à un seuil Si déterminé. Cette détection peut être réalisée localement, sans nécessairement faire appel au dispositif de supervision V du réseau et sans communiquer la mesure d'énergie à ce dispositif. Une telle détection locale peut permettre d'activer un dispositif également local de protection P, afin d'isoler une partie du réseau 1, comme cela a été expliqué précédemment.

Une telle défaillance d'isolation peut entraîner l'apparition d'une énergie résiduelle qui peut être beaucoup plus faible que l'énergie nominale du réseau. De plus, des dissymétries naturelles peuvent générer des biais dans le calcul local de l'énergie résiduelle (par exemple si la tension du conducteur commun Cc n'est pas exactement la moitié de la tension réseau). On favorise alors la détection et la localisation de cette défaillance en prenant la différence de ces énergies mesurées en amont et en aval de la ligne, à l'aide de deux dispositifs de détection D. On exploite alors les capacités de traitement du dispositif de supervision V auquel les mesures d'énergie résiduelles sont communiquées, comme cela a été présenté dans le cas précédent.

Dans d'autres cas, l'énergie résiduelle peut être relativement faible et il peut alors être avantageux de sommer les énergies résiduelles mesurées au cours de plusieurs périodes successives d'observation avant de procéder à la comparaison avec le seuil, afin d'étendre cette période d'observation.

Dans le cas d'un réseau isolé (type régime IT), qui aura la faculté de continuer à être pleinement opérationnel dans le cas d'un premier défaut d'isolement, un contrôleur permanent d'isolement (CPI) est obligatoirement présent afin de détecter ce premier défaut. Ce CPI mesure l'impédance entre le réseau et la masse mécanique ou la terre et pour ce faire, il injecte typiquement une tension de mode commun (une tension résiduelle) dans le réseau à une très basse fréquence (typiquement 1Hz). Lorsque le réseau est sain, il n'y a pas de courant de mode commun (courant résiduel) et donc pas d'énergie résiduelle. En cas de premier défaut d'isolement, le CPI provoquera l'apparition de courants résiduels et d'une énergie résiduelle, notamment à la fréquence d'excitation du CPI. Ainsi, on peut avantageusement mesurer une énergie résiduelle à la seule fréquence d'excitation du CPI afin de faciliter la localisation d'un défaut d'isolement. Pour ce faire, il faudra synchroniser le CPI et les dispositifs de détection D, par exemple par l'envoi d'une horloge de synchronisation sur le bus de communication BUS.

### Défaillance de type série (arc électrique série)

En référence à la figure 4c, une défaillance de type série, comme un arc série se produisant sur l'une des lignes L, le plus souvent sur une borne de connexion B, parfois au sein des conducteurs de puissance C1, C2, peut être modélisée comme un dipôle DP3 placé en série sur ce conducteur.

Les courants de réseau du côté de la source I_{net,s} et du côté de la charge I_{net,c} ne sont quasiment pas affectés par la présence de ce dipôle DP3. Mais la circulation d'un courant dans ce dipôle DP3 fait naître une tension V_{d} qui déséquilibre la tension portée par ce conducteur de puissance, alors que l'autre conducteur n'est pas affecté. Cette dysmétrie fait naître une tension résiduelle du côté de la source V_{res,s} et/ou du côté de la charge V_{res,c}.

En conséquence, l'occurrence d'un défaut de type série fait naître, sur une période d'observation déterminée, une énergie mixte E_{mix, s} ou E_{mix, c} d'un côté et/ou de l'autre de la ligne. Le défaut de type série génère également une variation d'énergie de réseau mais celle-ci est très largement inférieure à l'énergie nominale et il sera impossible de détecter de façon fiable et précoce l'occurrence d'un défaut série via l'analyse de l'énergie de réseau. En revanche, un défaut de type série ne génère pas de variation de l'énergie résiduelle.

En mesurant, au cours d'une période de temps j, dans une zone de mesure du réseau et à l'aide d'un dispositif de détection D d'identifiant i disposé dans cette zone, l'énergie mixte E^{j}ₘᵢₓ, ᵢ il est donc possible de détecter l'occurrence d'une telle défaillance, par exemple en comparant l'énergie mesurée E^{j}ₘᵢₓ, ᵢ à un seuil Si déterminé. Cette détection peut être réalisée localement, sans nécessairement faire appel au dispositif de supervision V du réseau et sans communiquer la mesure à ce dispositif. Une telle détection locale peut permettre d'activer un dispositif également local de protection P, afin d'isoler une partie du réseau, comme cela a été expliqué précédemment. On peut également utiliser une différence entre les tensions résiduelles V^{j}_{res, i} et V^{j}_{res, i+1} fournies respectivement par l'intermédiaire du bus de communication BUS par les dispositifs de détection Dᵢ, Dᵢ₊₁ pour détecter et localiser un défaut de type série.

On note que l'énergie mixte Eₘᵢₓ est provoquée par la dissymétrie entre le premier et le deuxième conducteur de puissance engendré par la présence du dipôle série DP3 qui modélise une défaillance de type série. Pour tirer entièrement profit de la capacité de détection à partir de l'énergie mixte, on cherchera donc à éviter de rendre intentionnellement dissymétriques les conducteurs de puissance C1, C2. On évitera pour cette raison qu'un des deux conducteurs de puissance soit confondu avec la masse mécanique du réseau. On évitera également d'insérer dans une ligne L un connecteur ou tout autre élément sur un seul des conducteurs de puissance.

En cas de dissymétrie « naturelle » du réseau produisant donc une énergie mixte dans certaines zones de mesure même en fonctionnement normal du réseau, cette énergie mixte d'équilibre peut être déterminée et prise en compte pour la détection d'une défaillance, par exemple en ajustant le niveau du seuil de comparaison Si, ou en identifiant une variation temporelle de l'énergie mixte. On peut ainsi prévoir une phase de calibrage des dispositifs de détection D du réseau 1 (ou du dispositif de supervision V), visant à entrer le niveau de la valeur seuil au-delà de laquelle une mesure d'énergie mixte ou de tension résiduelle témoigne de l'occurrence d'une défaillance d'une type série. Typiquement et à titre d'exemple, un arc électrique de type série produit une tension résiduelle comprise entre 20V et 50V. On peut alors choisir les seuils de détection de la différence des tensions résiduelles vers 2V et, pour l'énergie mixte, 2V que multiplie la valeur du courant Iₙₑₜ. Ainsi, on peut avantageusement faire évoluer le seuil de détection Si en fonction de la valeur moyenne du courant réseau Iₙₑₜ.

Comme dans les 2 types précédents de défaillances, on peut également fournir la mesure d'énergie mixte préparée par chacun des dispositifs de détection D au dispositif de supervision V, qui pourra alors détecter plus finement et localiser un défaut de type série par analyse des différences d'énergie mixte entre 2 dispositifs de détection Dᵢ et Dᵢ₊₁. On peut également traiter, en somme ou en différence, des mesures d'énergie successives, notamment pour permettre la détection des défauts de faible puissance sur une période d'observation plus grande. Les seuils de détection qui s'appliquent respectivement aux mesures d'énergies de réseau, résiduelles et mixte, ou à des différences de ces énergies entre deux dispositifs, peuvent être distincts les uns des autres. Il est précisé que selon les conventions et la nature du défaut (par exemple un arc série sur le premier conducteur de puissance C1 ou un arc série sur le deuxième conducteur de puissance C2, ces seuils peuvent être négatifs et la notion d'énergie « supérieure » à un seuil s'entend en valeur absolue.

Pour résumer cette partie de la description, on note que la mesure sur une période d'observation déterminée et dans une zone déterminée du réseau, de l'énergie réseau Eₙₑₜ, de l'énergie résiduelle Eᵣₑₛ et de l'énergie mixte Eₘᵢₓ permet de détecter et de localiser l'apparition de défaillances variées. Cette détection peut être réalisée localement dans la zone de mesure par la simple observation d'une énergie réseau, résiduelle ou mixte dépassant un seuil déterminé. La localisation plus précise de ces défaillances et la détection d'une plus grande variété de défaillances peuvent nécessiter d'exploiter les mesures de ces énergies entre deux zones de mesure du réseau électrique 1.

On note en particulier qu'il est possible d'exploiter la mesure de l'énergie mixte au niveau d'une unique zone de mesure pour détecter l'occurrence d'une défaillance de type série, tel qu'un arc électrique dans un conducteur d'une ligne du réseau ou d'un équipement, par exemple une source, ce qui n'était pas facilement possible avec les techniques connues de l'art antérieur. Cet aspect forme donc un avantage important de la solution qui fait l'objet de cette description.

Pour favoriser cette détection, les lignes L du réseau électrique 1 sont avantageusement conçues pour être le plus symétrique possible. A ce titre, il est avantageux de choisir des conducteurs de puissance reliant les équipements électriques E entre eux pour qu'ils soient identiques ou pour qu'ils présentent des géométries (diamètre et nature du conducteur et de l'isolant) identiques. On peut également prévoir que les conducteurs de puissance et que le conducteur commun soient assemblés parallèlement les uns aux autres pour former un harnais de câbles, par exemple à l'aide de serre-câble, voire un câble unique, par exemple en noyant les conducteurs dans une matière isolante. On limite ainsi les dissymétries d'interaction des conducteurs avec l'environnement.

Pour la même raison de recherche d'équilibre, et afin d'avoir des tensions résiduelles nulles en l'absence de défaut, le conducteur commun peut être relié à un point milieu des équipements électriques formant des sources ou des charges. Et on peut munir les équipements électriques E formant des sources ou des charges et ne disposant pas de point milieu, d'un pont résistif entre les deux conducteurs de puissance pour relier le conducteur commun au point milieu de ce pont résistif.

Pour pouvoir élaborer une mesure des énergies de réseau, résiduelles et/ou mixtes, les détecteurs de défaillance D sont munis de capteurs de tension et de courant permettant de former une image des tensions portées par les conducteurs ou circulant dans les conducteurs auxquels ils sont reliés, dans la zone de mesure. Avantageusement, ces capteurs présentent une bonne linéarité, sont faiblement impactés par l'environnement (la température, les contraintes mécaniques, etc) pour ne pas biaiser les calculs énergiques entre deux points distants du réseau et ne sont pas excessivement sensibles au vieillissement. Ils présentent également des bandes passantes de mesures étendues, de manière à ce que les énergies mesurées prennent en considération la disparité spectrale des signaux, tension et courants du réseau, notamment lors de la survenance d'une défaillance.

D'une manière générale, ces capteurs sont aptes à élaborer une mesure fidèle dans une gamme de fréquences comprise entre 0 Hz et 1kHz, voire 10kHz ou 100 kHz, voire même 1 MHz ou 10 MHz ou 100MHz. Les organes de mesures O1, O2 peuvent chacun comprendre un ou une pluralité de tels capteurs. Il peut notamment s'agir de capteurs travaillant dans des gammes de fréquences différentes. On peut ainsi envisager qu'un organe de mesure O1, O2 présente un capteur permettant de mesurer une composante continue d'un signal et/ou un capteur permettant de mesurer certaines composantes spectrales non continues d'un signal.

Avantageusement, les capteurs sont aptes à fournir des mesures d'une composante continue du courant ou de la tension du réseau 1, que celui-ci soit un réseau AC ou DC, avec un temps de réponse compatible avec un temps de latence à la détection requis, par exemple inférieur ou égale à la milliseconde. En conséquence, la bande passante de mesure de ces capteurs est typiquement comprise entre 0 Hz et 1kHz ou plusieurs kHz. La mesure des énergies à partir de mesures prises dans cette gamme de fréquences est suffisante pour détecter la plupart des défaillances, notamment les arcs électriques série ou parallèle, avec la réactivité requise.

Dans le cas d'un réseau alternatif AC présentant des équipements électriques actifs, sources ou charges, les énergies établies à partir de la mesure des composantes continues du courant et de la tension, peuvent témoigner d'une défaillance dans le fonctionnement de ces équipements. On peut également protéger les transformateurs de puissance contre les effets de la saturation magnétique induite par ces composantes continues. Dans le cas d'un réseau alternatif AC avec un schéma de mise à la terre de type IT (isolé), la mesure des composantes continues permettra également de localiser le premier défaut comme évoqué précédemment.

Les capteurs peuvent être également aptes à fournir une mesure fidèle des tensions et des courants dans la fréquence du réseau pour détecter les défaillances de type surconsommation ou défaut d'isolement. Ils peuvent également fonctionner au-delà de ces fréquences dans une gamme de très haute fréquence au-delà de 100 MHz. Ceci est particulièrement vrai pour détecter des défauts de type décharge partielle dans des isolants des conducteurs du réseau.

### Dispositif de détection

Les principes sous-tendant l'invention ayant été posés, on présente maintenant en détail un dispositif de détection D conforme à l'invention, et représenté sur la figure 5. Comme on l'a déjà énoncé en référence à la description de la figure 1, un tel dispositif de détection D est adapté pour être relié aux conducteurs de puissance C1, C2 du réseau 1 et au conducteur commun Cc, et au niveau d'une zone de mesure de ce réseau 1. Ces conducteurs de puissance peuvent être ceux formant une ligne L du réseau 1, ou préférentiellement ceux internes aux équipements électriques E du réseau. Dans un tel cas, les organes de mesure O1, O2 d'un dispositif de détection D sont placées de préférence en amont des bornes B reliant une source aux lignes de distribution L du réseau et, de préférence, en aval des bornes B reliant une charge à ces lignes L. Ce faisant, on sera capable de détecter et localiser un défaut dans ces bornes B.

Dans sa version la plus simple, le dispositif de détection D est prévu pour détecter à minima les défaillances de type série, et il est donc configuré pour élaborer une grandeur représentative d'une énergie mixte qui transite dans la zone de mesure et au cours d'une période d'observation donnée.

A cet effet, le dispositif de détection D comprend un premier organe de mesure O1, couplé à certains au moins des conducteurs, permettant d'élaborer une première grandeur représentative Vᵣₑₛ de la tension de mode commun des conducteurs de puissance C1, C2, c'est-à-dire de la tension résiduelle. Ce premier organe O1 peut ainsi comprendre des capteurs de la tension présente sur chacun des conducteurs de puissance C1, C2 par rapport au conducteur commun Cc. On donnera dans une partie ultérieure de cette description plusieurs modes de mise en œuvre préférés de ce premier organe O1.

Le dispositif de détection D comprend également un deuxième organe de mesure O2, couplé à certains au moins des conducteurs, et permettant d'élaborer une deuxième grandeur représentative Iₙₑₜ d'un courant de réseau. A titre d'exemple, ce deuxième organe O2 peut comprendre un premier capteur de courant pour mesurer le courant circulant sur le premier conducteur de puissance C1 et un deuxième capteur de courant pour mesurer le courant circulant sur le deuxième conducteur de puissance C2, la différence des mesures fournies par ces capteurs étant représentative de la deuxième grandeur Iₙₑₜ. Dans certains cas, on peut prévoir un unique capteur de courant pour mesurer sur l'un seulement de ces conducteurs, une grandeur que l'on assimile en première approximation au courant de réseau, et donc à la deuxième grandeur Iₙₑₜ.

Avantageusement, le capteur ou les capteurs de courant du deuxième organe sont des capteurs à effet Hall, à Effet Neel^{®} ou comprenant un shunt résistif de manière à prélever une composante continue des courants mesurés. On peut prévoir que le capteur ou les capteurs de courant du deuxième organe comprennent des capteurs de type Rogowski ou des transformateurs à air. On profite alors de la bande passante étendue, de la linéarité et de la stabilité de ces types de capteurs lors de la mesure de composantes spectrales non continues. Ceci est particulièrement vrai dans le cas d'une recherche de défaut de type décharge partiel.

Quelle que soit la nature des composants avec lesquels sont mis en œuvre les premier et deuxième organes de mesure O1, O2, ceux-ci permettent d'élaborer directement ou indirectement (c'est-à-dire à l'aide d'un calculateur UP qui sera présenté ci-après) une grandeur représentative Iₙₑₜ du courant de réseau et une grandeur représentative Vᵣₑₛ de la tension résiduelle. Ces deux grandeurs permettent d'établir une image de l'énergie mixte Eₘᵢₓ qui transite sur une période d'observation déterminée, dans la zone de mesure du dispositif de détection D définie par sa position dans le réseau. Pour permettre cela, le dispositif de détection D comprend également un calculateur UP, relié au premier et au deuxième organe de mesure O1, O2. Ce calculateur UP peut prendre toute forme qui convient, mais il s'agit préférentiellement d'un calculateur numérique présentant des entrées permettant de numériser à grande fréquence les mesures analogiques fournies par les organes de mesure O1, O2. Ce calculateur peut être mis en œuvre par un microcontrôleur, un FPGA, un DSP, un ASIC ou toute autre forme de dispositif de calcul numérique ou analogique qui convient.

Le dispositif de détection D peut éventuellement comprendre un convertisseur CON, représenté en pointillés sur la figure 5, apte à prélever de l'énergie présente dans les connecteurs de puissance C1, C2 et/ou dans le connecteur commun Cc pour alimenter électriquement le calculateur UP et tous les autres éléments actifs qui composent le dispositif D, étant entendu que la puissance nécessaire est particulièrement réduite. Lorsqu'il est conçu pour être relié à un bus de communication BUS, comme cela a été présenté en relation avec la figure 1, le dispositif de détection D peut alternativement être alimenté par un port dédié de ce bus.

Pour être complet, mais sans que cela ne forme une caractéristique essentielle, le dispositif de détection peut comprendre également un contrôleur réseau NET, qui peut être mis en œuvre par le calculateur UP, et permettant d'interfacer le dispositif D avec le bus de communication BUS. Le dispositif D est associé à un identifiant, tel qu'une adresse réseau, qui permet donc de l'identifier sur le réseau. Le bus BUS permet de communiquer au calculateur UP une information d'horloge, ou le dispositif D peut présenter une borne d'horloge dédiée permettant de recevoir cette information. Le calculateur UP peut de la sorte horodater les données qu'il élabore avant de les placer sur le bus de communication BUS. De la sorte, le dispositif de supervision V auquel plusieurs dispositifs de détection D similaires à celui présenté sur la figure 5 sont reliés comme on l'a déjà vu, peut ordonner les données reçues de ces dispositifs D et les exploiter dans une séquence temporellement cohérente.

Le calculateur UP du dispositif de détection D est configuré matériellement ou par logiciel pour faire l'acquisition des mesures fournies par le premier et le deuxième organe de mesure O1, O2, et pour déterminer une image de l'énergie mixte E^{j}ₘᵢₓ qui transite, pendant une période de temps j donnée, dans la zone de mesure. La fréquence d'acquisition des mesures par le calculateur est typiquement inférieure à la milliseconde, par exemple elle peut être de l'ordre de 100 microsecondes ou 10 microsecondes, voire 100 ns ou moins selon la bande passante des organes de mesure O1, O2. La période d'observation peut être quant à elle comprise entre 100 ns et 10s. On précise que le calculateur UP peut être configuré pour traiter numériquement les mesures fournies par les organes de mesure O1, O2 ou être configuré pour combiner une pluralité de mesures fournies par chacun de ces organes O1, O2 pour déterminer l'image de l'énergie mixte E^{j}ₘᵢₓ. Par exemple, le calculateur peut être configuré pour intégrer une mesure fournie lorsqu'un capteur d'un organe O1, O2 délivre une information proportionnelle à la dérivée temporelle. Il peut être configuré pour additionner une mesure continue de courant/tension et une mesure de variation de ce courant/tension (après son intégration), lorsque ces deux mesures sont fournies séparément pour l'un des deux organes de mesure O1 et/ou O2.

Le calculateur UP peut être également configuré pour exploiter l'énergie mixte déterminée E^{j}ₘᵢₓ afin de détecter une défaillance de type série dans le réseau, comme cela a été présenté dans une section précédente de cette description. Il peut notamment s'agir de déterminer si cette énergie mixte déterminée E^{j}ₘᵢₓ, ou une variation de cette énergie entre deux périodes d'observation distinctes, excède un seuil prédéterminé. Comme on l'a vu également, le calculateur peut être configuré pour sommer les énergies mixtes déterminées E^{j}ₘᵢₓ, E^{j+1}ₘᵢₓ ..., E^{j+n}ₘᵢₓ sur des périodes d'observation j, j+1,...,j+n consécutives. L'énergie mixte cumulée est alors comparée à un seuil afin de déterminer l'occurrence d'une défaillance.

Lorsqu'une telle défaillance est avérée, et quelle que soit la manière avec laquelle le calculateur exploite la ou les mesure(s) d'énergie mixte E^{j}ₘᵢₓ, le calculateur UP peut générer un signal S indiquant cette défaillance, le signal pouvant alors être reporté sur une borne de détection du dispositif D. Dans un tel cas d'usage du dispositif de détection D, on comprend que la présence du bus de communication BUS n'est pas nécessaire. Alternativement, le signal S peut être placé sur le bus de communication BUS. Dans une autre alternative encore, le calculateur UP peut se contenter d'élaborer par calcul les données représentatives de l'énergie mixte E^{j}ₘᵢₓ et de placer ces données sur le bus de communication BUS. Dans cette dernière alternative, la détection d'une défaillance du réseau est entièrement mise en œuvre par le dispositif de supervision V comme cela a été présenté antérieurement.

Dans un mode de mise en œuvre plus complet du dispositif de détection D, celui-ci peut comprendre d'autres organes de mesure ou des premier et deuxième organes de mesures O1, O2 plus complets permettant au calculateur UP de déterminer, en plus de l'image de l'énergie mixte E^{j}ₘᵢₓ, l'image de l'énergie de réseau E^{j}ₙₑₜ et de l'énergie résiduelle E^{j}ᵣₑₛ qui transitent dans la zone de mesure pendant la période d'observation j déterminée. Ces organes, outre la deuxième grandeur Iₙₑₜ représentative du courant de réseau et la première grandeur représentative Vᵣₑₛ de la tension résiduelle, permettent d'établir une troisième grandeur représentative Vₙₑₜ de la tension de réseau et une quatrième grandeur représentative Iᵣₑₛ du courant résiduel. Ce mode de mise en œuvre plus complet est symbolisé par les flèches pointillées Vₙₑₜ et Iᵣₑₛ sur la figure 5.

### Dispositif de détection intégré à un équipement actif

Un dispositif de détection D peut être intégré dans un équipement électrique E comprenant une charge ou une source active, par exemple un onduleur, ou une génératrice dont on veut surveiller le bon fonctionnement. Dans ce cas, et afin de pouvoir détecter un arc série, on positionnera le dispositif de détection D au plus près de la partie active de l'équipement E, i.e. juste avant les interrupteurs de puissance, et en aval des bornes de connexion B de cet équipement et en aval d'un éventuel dispositif de protection P lorsque cet équipement E est une charge. On placera de façon préférentielle un pont diviseur résistif entre les conducteurs de puissance C1, C2 dont le point milieu est relié au conducteur commun au plus près de la charge active. On pourra ainsi mesurer une énergie mixte, image de la présence d'un défaut en série dans les conducteurs internes à l'équipement E surveillé.

De même que l'on a cherché à distinguer les énergies dans le réseau, on peut chercher à distinguer les énergies consommées par une charge. Pour cela, on peut définir 4 types d'énergies :
- Une énergie dite « utile », caractérisée par des spectres de courant-tension à la fréquence du réseau, entre 0 et 10 Hz pour un réseau continu DC ou à +/- 5 Hz de la fréquence de réseau pour un réseau alternatif AC.
- Une énergie de distorsion harmonique, caractérisée par des spectres de courant-tension dans une bande de +/- 5 Hz autour des multiples de la fréquence de réseau (pour un réseau alternatif). Cette énergie est essentiellement réactive.
- Une énergie de commutation, caractérisée par des spectres de courant-tension à des fréquences multiples d'une fréquence de hachage FHACH de la charge active. Cette énergie est limitée à des bandes de +/- 5 Hz autour de ces fréquences multiples n*FHACH.
- Une énergie additionnelle qui n'est dans aucune des bandes ci-dessus. A priori on ne retrouve dans cette bande que du bruit ou bien de l'énergie en cas d'arc électrique (série ou parallèle) ou de court-circuit.

Un dispositif de détection D intégré dans l'équipement E établira les énergies de réseau Eₙₑₜ, résiduelle Eᵣₑₛ et mixte Eₘᵢₓ comme cela a été présenté dans les sections précédentes de cette description afin, par exemple, de transmettre ces informations au dispositif de supervision V. De plus, le dispositif de détection D pourra établir une décomposition de ces énergies selon les quatre catégories précitées afin d'en identifier les contributeurs. Pour cela, le dispositif de détection D peut appliquer un filtrage sur les grandeurs fournies par les organes de mesure O1, O2 afin de séparer ces grandeurs selon les différentes bandes spectrales décrites, avant de procéder au calcul des énergies dans chacune de ces bandes à l'aide du calculateur UP.

Ce filtrage peut mettre en œuvre des filtres en peigne implémentés par le calculateur UP, afin de pouvoir notamment asservir la fréquence du peigne avec la fréquence de hachage. A cet effet, on peut prévoir que cette fréquence de hachage soit fournie sous la forme d'une horloge de hachage FHACH issue de la charge active et présentée sur une borne de connexion dédiée du dispositif de détection (représentée sur la figure 5).

On peut ainsi établir par l'intermédiaire du calculateur UP :
- une énergie de réseau « Eₙₑₜ utile » comme étant l'énergie utile dans la charge ou la source. Cette énergie peut révéler une surcharge ou un arc parallèle.
- Une énergie de réseau « Eₙₑₜ de commutation » comme étant l'énergie perdue dans les structures de commutation de l'équipement électrique E. Cette énergie peut révéler une défaillance de commutation, comme un court-circuit de bras (non respects des temps morts) ou une fatigue d'interrupteur.
- Une énergie de réseau « Eₙₑₜ additionnelle » comme étant l'énergie additionnelle, par exemple due à un arc parallèle ou série ou un court-circuit.
- Une énergie mixte « Eₘᵢₓ de commutation » représentative d'une défaillance de commutation de façon plus fine que l'énergie mixte Eₘᵢₓ seule. On peut notamment identifier la présence d'un arc série dans l'équipement E en éliminant l'énergie mixte de commutation de l'énergie mixte Eₘᵢₓ.

Ces énergies peuvent être placées sur le bus de communication BUS et transmises au dispositif de supervision V pour y être exploitées.

### Mode de mise en œuvre préféré du premier organe de mesure

Pour assurer une détection et une localisation de défaillance, et en particulier d'un arc série dans un réseau alternatif ou continu, il peut être suffisant, comme on l'a vu, de mesurer les composantes continues d'une tension résiduelle Vᵣₑₛ et d'un courant de réseau I_{Net}. Ces mesures sont réalisées par, respectivement, le premier et le deuxième organe de mesure O1, O2 du dispositif de détection D.

Pour la mesure de la composante continue de la tension de mode commun, i.e. la tension résiduelle Vᵣₑₛ, on peut munir le premier organe de mesure O1 d'un pont diviseur résistif de tension, une première électrode T1 du pont étant électriquement reliée au premier conducteur de puissance C1, une seconde électrode T2 étant électriquement reliée au deuxième conducteur de puissance C2 et une troisième électrode T3 étant électriquement reliée au point milieu du pont. La tension se développant entre ce point milieu, sur la troisième électrode T3, et le conducteur commun CC via un dipôle de mesure SH fournit la tension de mode commun. Typiquement ce dipôle est formé d'une résistance. Un schéma de principe d'un tel pont est représenté sur la figure 10 dans lequel les résistances R1, R2 formant le pont sont précisément choisies pour présenter la même valeur, à 1% près, voire à 0.1% ou même 0,01% près et limitant au maximum leur dérive dans le temps et en température. Dans un tel schéma, la grandeur représentative de la tension de mode commun Vᵣₑₛ est égale à la tension de mode commun présente sur les deux conducteurs de puissance multipliée par un gain égal à SH/[R1/2+SH]. Ce gain permet de réduire la dynamique de la mesure pour l'adapter à celle de l'électronique de l'organe de mesure. A titre d'illustration, en choisissant R1 = 1 MOhms, et SH = 50 kOhms, un gain de 1/11 permet de ramener une tension de mode commun de 50V sur les conducteurs de puissance à une grandeur représentative Vᵣₑₛ de l'ordre de 5V pour qu'elle puisse être traitée par le reste de l'électronique de l'organe de mesure. On choisira bien entendu les valeurs des résistances R1, R2 et SH afin de s'adapter aux grandeurs du réseau et à la dynamique de l'électronique de mesure.

Comme on l'a déjà précisé, le dispositif de détection D est muni de bornes de connexion B destiné à associer le dispositif aux conducteurs C1, C2, CC. Ces bornes B sont donc également électriquement reliées aux électrodes du pont résistif.

A titre d'exemple, le pont diviseur résistif peut être composé d'une résistance en couche mince ou en couche épaisse (« thin film » ou « thick film » selon l'expression anglo-saxonne consacrée) permettant d'assurer une tenue en tension adéquate et de maîtriser le rapport de transformation sans dérive thermique ou dans le temps. Pour s'assurer d'une parfaite symétrie entre les deux éléments résistifs R1, R2, et ainsi réduire les dérives dans le temps et en fonction de la température, on utilisera de façon privilégiée un diviseur résistif dit « à 3 terminaux » pour former ces éléments résistifs.

Lorsqu'il est choisi de mesurer des composantes non continues de la tension résiduelle, il est préférable que le capteur permettant cette mesure soit insensible à une éventuelle composante continue, soit parfaitement linéaire, que son gain soit maîtrisé et ne dérive ni en température ni dans le temps. Ceci est particulièrement vrai pour une détection de défauts de type décharges partielles. A cet effet, et dans un mode préféré de mise en œuvre dont un schéma de principe est représenté sur la figure 6, on propose d'utiliser deux éléments capacitifs EC1, EC2 disposés en pont entre les deux conducteurs de puissance C1, C2 présentant des valeurs de capacité sensiblement identiques entre elles, à 1%, voire 0,1%, voire 0,01% près. Ces éléments sont respectivement reliés en un point milieu M. Le point milieu M est électriquement relié au conducteur commun Cc via un dipôle de mesure SH de la tension de mode commun.

Les courants I1, I2 circulants dans les éléments capacitifs EC1, EC2 sont respectivement proportionnels aux dérivées, en fonction du temps, des potentiels V_{c1}, V_{c2} portés par les conducteurs de puissance C1, C2. Les valeurs de capacité des éléments capacitifs EC1, EC2 étant identiques, le courant différentiel I1-I2 est proportionnel à la dérivée de V_{c1}+V_{c2}, c'est à dire la tension de mode commun Vᵣₑₛ. Ainsi, il suffit de mesurer ce courant différentiel I1-I2 par exemple par l'intermédiaire d'un capteur de courant disposé dans une branche du circuit reliant le point milieu M entre les éléments capacitifs et le conducteur commun Cc, puis de l'intégrer en fonction du temps pour disposer de la tension résiduelle Vᵣₑₛ. A cette fin, le dipôle de mesure SH placé entre le point milieu M et le conducteur commun Cc fait partie du capteur de courant et présente une faible impédance, inférieure à 1 kOhm, voire même inférieure à 1 Ohm. L'intégration n'est pas nécessairement réalisée analogiquement dans le premier organe de mesure lui-même comme cela est symbolisé sur la figure 6, et le calculateur UP peut être configuré pour réaliser cette opération.

On peut alternativement mesurer directement des composantes non continues de la tension de mode commun Vᵣₑₛ entre le point milieu M et le conducteur commun Cc en choisissant une impédance du dipôle de mesure SH élevée, supérieure à 1 kOhm, voire même supérieure à 1 MOhm. L'organe O1 comprend alors un diviseur capacitif délivrant la tension résiduelle par rapport au conducteur commun Cc. Cette seconde solution est cependant moins adaptée aux environnements électromagnétiques sévères (comme dans un aéronef), mais peut convenir dans une ferme photovoltaïque en complément des composantes continues.

Pour s'assurer d'une parfaite symétrie entre les deux éléments capacitifs EC1, EC2, et ainsi réduire les dérives dans le temps et en fonction de la température, on utilisera de façon privilégiée un condensateur dit « à 3 terminaux » pour former ces éléments capacitifs.

De tels condensateurs comprennent des électrodes de type A, de type B et de type G (figure 7), chaque type étant électriquement associé à un terminal, et empilés les uns sur les autres et isolés entre eux par un diélectrique, et suivant une alternance A, G, B, G, A, G, B, etc. L'électrode G du condensateur constitue directement le point milieu M, relié au conducteur commun Cc via le dipôle de mesure SH, et les électrodes de types A et B sont respectivement reliées aux conducteurs de puissance C1, C2 par l'intermédiaire des trois terminaux du condensateur. L'avantage de cette structure est d'obtenir des éléments capacitifs EC1, EC2 quasi identiques, invariants dans le temps et stables en température entre le terminal de type G et le terminal de type A d'une part, et entre le terminal de type G et le terminal de type B d'autre part. Les condensateurs à trois terminaux présentent également une très faible inductance parasite, ce qui permet de procéder à des mesures à très hautes fréquences.

Le diélectrique du condensateur peut être du type C0G ou NPO. On peut employer également un diélectrique à base de papier, éventuellement chargé d'huile, ou bien de mica ou d'autres isolants, permettant d'obtenir un excellent comportement en hautes fréquences, stables dans le temps, pour des tensions moyennes ou très élevées.

Le condensateur peut être un condensateur à film, dans lequel chaque type de conducteur et le diélectrique se présentent sous la forme d'un film, et sont empilés les uns sur les autres. L'empilement peut être enroulé pour former une capacité à trois terminaux cylindrique ou parallélépipédique.

On peut bien entendu étendre ces concepts pour former des capacités présentant plus de trois terminaux, ce qui peut être utile lorsque le réseau est triphasé par exemple.

De manière avantageuse, on peut prévoir que le premier organe de mesure O1 permette également d'établir la tension de réseau Vₙₑₜ, c'est-à-dire la tension de mode différentielle, en plus de la tension résiduelle Vᵣₑₛ, c'est-à-dire la tension de mode commun. On peut par exemple utiliser un diviseur de tension résistif et/ou capacitif selon la nature des composantes spectrales de la tension de réseau Vₙₑₜ que l'on souhaite mesurer.

On a ainsi représenté sur la figure 11, un pont diviseur résistif à 4 résistances R1, R1', R2, R2' et à 5 électrodes T1 à T5. On retrouve bien les 2 électrodes T1, T2 permettant de relier le pont aux conducteurs C1, C2, la troisième électrode T3 permettant de prélever et mesurer une tension de point milieu correspondant à la tension de mode commun entre les deux conducteurs de puissances. La résistance série R1+R1' formée des résistances R1, R1' disposées d'un côté du point milieu est donc égale à la résistance série R2+R2' formée des résistances R2, R2' disposées de l'autre côté du pont par rapport au point milieu. On a également prévu des électrodes complémentaires T4, T5 disposés au niveau des points intermédiaires de liaison série des résistance dans chaque branche du pont, permettant de fournir une tension image de la tension de réseau Vₙₑₜ par l'intermédiaire d'un gain contrôle (défini par la relation (R1+R1')/(R1+R1'+R2'+R2). La tension prélevée entre les électrodes complémentaires T4, T5 est ainsi compatible avec le reste du traitement opéré par la chaine d'acquisition électronique. Par exemple si la tension de réseau Vₙₑₜ est de l'ordre de 800V, on pourra choisir les résistances du pont pour que le gain soit de l'ordre de 1/100.

A titre d'illustration, on pourra choisir les deux éléments résistifs R1, R2 pour qu'ils soient égaux entre eux, par exemple compris entre 10 kOhms et 1MOhms, et égaux à 99 fois à la première résistance R1' reliée au point milieu T3. On choisit également l'autre résistance R'2 reliée au point milieu, de l'autre côté de ce point, pour qu'elle présente la même valeur que la première résistance R1'. Le gain de contrôle appliqué à la tension de mode différentielle présente entre les deux conducteurs de puissance, égale (R1+R1')/(R1+R1'+R2'+R2), est alors égale dans ce cas à R'1/(R1+R'1).

Ainsi, et de façon préférentielle, le pont résistif est mis en œuvre par un composant unique de type diviseur résistif apparié, c'est-à-dire dont la valeur de certaines résistances est fixée selon un rapport déterminé à l'avance par rapport aux autres résistances, et dans lequel l'ensemble des résistances sont réalisées sur un même support (« thick film » ou « thin film ») afin de réduire les dérives thermiques. On dispose ainsi d'un diviseur résistif à 3 terminaux ou à 5 terminaux, selon le mode de mise en œuvre choisi.

Dans le cas de la mesure de composantes non continues, et afin d'améliorer la performance en environnement sévère, il suffit de réaliser que le courant de mode commun I1+I2 circulant dans les deux éléments capacitifs EC1, EC2 du diviseur capacitif présenté sur la figure 6 forme une image de la dérivée en fonction du temps de la tension de mode différentielle Vₙₑₜ. En munissant le premier organe O1 d'un capteur de courant de mode commun, il est possible d'établir cette tension de mode différentiel Vₙₑₜ. Ce capteur de courant de mode commun peut être formé de deux bobines à air, par exemple deux sondes de Rogowski, respectivement disposées à proximité des éléments capacitifs EC1, EC2.

On a ainsi représenté sur la figure 7, un exemple de mise en œuvre de ces principes. On a formé un condensateur cylindrique à trois terminaux à partir de films de type A, B, G enroulés comme cela a été décrit précédemment, et dont les trois terminaux T1, T2, T3 sont respectivement électriquement reliés au premier conducteur de puissances C1, au conducteur commun via le dipôle SH et au deuxième conducteur de puissance C2. La résistance du dipôle de mesure SH disposée entre le terminal T2 (formant dans le condensateur le point milieu M entre les deux éléments capacitifs EC1, EC2) et le conducteur commun C permet d'extraire une grandeur représentative de la tension de mode commun Vᵣₑₛ, comme cela a été décrit précédemment. Deux capteurs de courant de type Rogowski RG1, RG2 sont disposés en enroulement autour du condensateur cylindrique de sorte à prélever une image des courants I1, I2 circulant dans le condensateur. Les grandeurs fournies par ces capteurs peuvent être combinées pour donner une image de la tension de mode différentiel Vₙₑₜ.

Dans une variante avantageuse, les capteurs de courant permettant d'élaborer des images de la tension de mode différentiel Vₙₑₜ et/ou de la tension de mode commun Vᵣₑₛ mettent en œuvre une technologie de bobine planaire. On peut dans ce cas plan réaliser deux types de bobines disposées dans des plans parallèles, mais distincts, qui permettent de mesurer respectivement le courant de mode commun (image de la dérivée de la tension de mode différentiel Vₙₑₜ) et le courant de mode différentiel (image de la dérivée de la tension de mode commun Vᵣₑₛ). Ces deux plans peuvent être localisés dans des couches différentes d'une carte à circuit imprimé multicouche dans lesquels on a localisé les bobines planaires.

Comme cela est représenté sur les figures 8a, 8b, cette carte à circuit imprimé peut comprendre, sur une première couche, deux pistes P1, P2 respectivement électriquement reliées aux conducteurs de puissance C1, C2. Ces pistes sont également reliées au condensateur trois terminaux C3 dont le point milieu M est électriquement relié au conducteur commun Cc via un dipôle de mesure SH, formé ici d'un simple conducteur de manière à former le courant différentiel. Les bobines planaires de mesures du courant différentiel Bcd, par exemple quatre de ces bobines formées de deux paires de bobines montées en antisérie (figure 8a), peuvent être placées sur une deuxième couche de la carte et les bobines planaires de mesure de courant commun Bcc, qui peuvent être quatre également, peuvent être placées sur une troisième couche de la carte (figure 8b).

Cette variante est avantageuse en ce qu'elle permet d'éliminer l'influence d'un courant circulant dans le conducteur commun, quelle que soit sa fréquence. Les bobines planaires délivrent une force électromotrice proportionnelle à la dérivée seconde de la tension mesurée par rapport eu temps, qu'il faut donc intégrer deux fois avant de procéder au calcul des énergies. Ce montage est réalisé préférentiellement selon une technologie de carte à circuit imprimé pour les applications de puissance afin de maitriser la géométrie des bobines et d'obtenir un rapport de transformation connu sans calibrage et avec une dérive extrêmement faible en température et dans le temps. On note que cette approche, d'une manière générale, peut être mise en œuvre pour mesurer la tension de mode différentiel Vₙₑₜ ou la tension de mode commun Vᵣₑₛ.

D'une manière générale on pourra munir l'organe de mesure O1 de capteurs de la composante continue et de la composante variable de la tension de mode commun Vᵣₑₛ. On pourra également le munir de capteurs de la composante continue et de la composante variable de la tension de mode différentiel Vₙₑₜ.

Bien entendu l'invention n'est pas limitée aux modes de mise en œuvre décrits et on peut y apporter des variantes de réalisation sans sortir du cadre de l'invention tel que défini par les revendications.

Ainsi, un dispositif D conforme à l'invention prévoit d'élaborer une grandeur représentative de l'énergie mixte Eₘᵢₓ à partir de la tension de mode commun et du courant de réseau et qui transite dans la zone de mesure. Cette grandeur est traitée et comparée à un seuil pour identifier une défaillance. On comprend parfaitement que la grandeur représentative de l'énergie mixte peut correspondre à la tension de mode commun que l'on compare à un seuil modulé selon l'intensité du courant de réseau. Dans tous les cas la première et la deuxième grandeur entrant dans la composition de l'énergie mixte Eₘᵢₓ est exploitée pour générer un signal S indiquant la défaillance du réseau. Il n'est donc pas nécessaire qu'un procédé de détection conforme à l'invention mette en œuvre un calcul formel d'énergie, bien que cela fasse un mode particulier de mise en œuvre.

## Revendications

1. Organe de mesure (O1) d'une grandeur représentative d'une tension de mode commun (Vᵣₑₛ) dans un réseau électrique (1) ou dans un équipement (E), le réseau (1) ou l'équipement (E) comprenant au moins un premier conducteur de puissance (C1) et un deuxième conducteur de puissance (C2), l'organe de mesure (O1) comprenant deux éléments capacitifs (EC1, EC2) destinés à être disposés en pont entre les deux conducteurs de puissance (C1, C2) 1es deux éléments capacitifs (EC1, EC2) étant reliés en un point milieu (M),
l'organe de mesure comprenant également un dipôle de mesure (SH),
ledit organe de mesure (O1) étant **caractérisé en ce que** les deux éléments capacitifs (EC1, EC2) présentent des valeurs de capacité identiques entre elles, et
**en ce que** le dipôle de mesure (SH) est relié d'une part au point milieu (M) et d'autre part à une borne de connexion destinée à être électriquement reliée à un conducteur commun (Cc) dont on a équipé le réseau électrique (1) ou l'équipement (E).

2. Organe de mesure (O1) selon la revendication précédente dans lequel le dipôle de mesure (SH) présente une impédance inférieure à 1kOhms, le dipôle (SH) étant apte à développer une tension proportionnelle à la dérivée par rapport au temps d'une tension de mode commun (Vᵣₑₛ) présente entre les deux conducteurs de puissance (C1, C2).

3. Organe de mesure (O1) selon la revendication 1 dans lequel le dipôle de mesure (SH) présente une impédance supérieure à 1kOhms, le dipôle (SH) développant une tension proportionnelle à une tension de mode commun (Vᵣₑₛ) présente entre les deux conducteurs de puissance (C1, C2).

4. Organe de mesure (O1) selon l'une des revendications précédentes dans lequel les éléments capacitifs (EC1, EC2) sont formés d'un condensateur à trois terminaux, un premier terminal étant destiné à être électriquement relié à l'un des conducteurs de puissance (C1, C2), un deuxième terminal étant destiné à être électriquement relié à l'autre des conducteurs de puissance (C1, C2) et le troisième terminal étant destiné à être relié au conducteur commun (Cc).

5. Organe de mesure (O1) selon la revendication précédente dans lequel le condensateur à trois terminaux est réalisé à partir de seulement 3 électrodes.

6. Organe de mesure (O1) selon l'une des deux revendications précédentes dans lequel le condensateur à trois terminaux est réalisé avec des feuilles empilées puis enroulées pour constituer un cylindre ou un parallélépipède à 3 terminaux.

7. Organe de mesure (O1) selon l'une des revendications précédentes, comprenant de plus une résistance à trois électrodes présentant un point milieu, la première électrode étant destinée à être électriquement reliée au premier conducteur de puissance (C1), la seconde électrode étant destinée à être électriquement reliée au deuxième conducteur de puissance (C2), la tension de mode commun (Vᵣₑₛ) étant présente entre le point milieu de la résistance à trois électrodes et le conducteur commun (Cc) .

8. Organe de mesure (O1) selon l'une des revendications précédentes comprenant un capteur de courant, apte à mesurer le courant de mode différentiel circulant dans les deux éléments capacitifs (EC1, EC2), pour établir une grandeur représentative de la tension de mode commun (Vᵣₑₛ), et formé de au moins quatre bobines à air respectivement disposées à proximité des éléments capacitifs (EC1, EC2).

9. Organe de mesure (O1) selon l'une des revendications précédentes, comportant en outre un capteur de courant, apte à mesurer le courant de mode commun circulant dans les deux éléments capacitifs (EC1, EC2) pour établir une grandeur représentative d'une tension de mode différentiel (Vₙₑₜ).

10. Organe de mesure (O1) selon la revendication précédente dans lequel le capteur de courant apte à mesurer le courant de mode commun est formé de au moins deux bobines à air respectivement disposées à proximité des éléments capacitifs (EC1, EC2).

11. Organe de mesure (O1) selon l'une des revendications précédentes comprenant en outre un capteur de la composante continue de la tension de mode commun (Vᵣₑₛ).

12. Organe de mesure (O1) selon l'une des revendications précédentes comprenant en outre un capteur de la composante continue de la tension de mode différentiel (Vₙₑₜ).

13. Dispositif de détection (D) d'une défaillance dans un réseau électrique (1), le réseau électrique (1) comprenant au moins un équipement électrique (E) électriquement relié à un premier conducteur de puissance (C1) et à un deuxième conducteur de puissance (C2), le réseau étant également muni d'un conducteur commun (Cc), le dispositif (D) étant destiné à être relié aux conducteurs de puissance (C1, C2) et au conducteur commun (Cc) au niveau d'une zone de mesure et comprenant :
- un premier organe de mesure (O1) conforme à l'une des revendications précédentes ;
- un deuxième organe de mesure (O2) permettant d'élaborer une deuxième grandeur (Iₙₑₜ) représentative d'un courant de réseau circulant les conducteurs de puissance (C1, C2);
- un calculateur, relié au premier et au deuxième organe de mesure, le calculateur étant configuré pour déterminer, sur une période d'observation déterminée, une grandeur représentative d'une énergie dite « mixte » (Eₘᵢₓ) définie comme l'intégrale sur la période d'observation déterminée du produit de la tension de mode commun et du courant de réseau et transportée dans la zone de mesure, la grandeur représentative de l'énergie mixte (Eₘᵢₓ) étant déterminée à partir de la première grandeur (Vᵣₑₛ) et de la deuxième grandeur (Iₙₑₜ).

14. Dispositif de détection (D) selon la revendication précédente dans lequel le deuxième organe de mesure (O2) comprend une bobine à air, par exemple de type Rogowski.

15. Dispositif de détection (D) selon la revendication précédente dans lequel le deuxième organe de mesure (O2) comporte également un capteur de courant continu, par exemple un capteur à Effet Néel^{®}.

## Patentansprüche

1. Organ (O1) zum Messen einer Größe, die eine Gleichtaktspannung (Vᵣₑₛ) in einem elektrischen Netz (1) oder in einer Ausrüstung (E) darstellt, wobei das Netz (1) oder die Ausrüstung (E) mindestens einen ersten Leistungsleiter (C1) und einen zweiten Leistungsleiter (C2) umfasst, wobei das Messorgan (O1) zwei kapazitive Elemente (EC1, EC2) umfasst, die dazu bestimmt sind, als Brücke zwischen den zwei Leistungsleitern (C1, C2) angeordnet zu werden, wobei die zwei kapazitiven Elemente (EC1, EC2) an einem Mittelpunkt (M) verbunden sind, wobei das Messorgan auch einen Messdipol (SH) umfasst, wobei das Messorgan (O1) **dadurch gekennzeichnet ist, dass** die zwei kapazitiven Elemente (EC1, EC2) untereinander identische Kapazitätswerte aufweisen, und dadurch, dass der Messdipol (SH) einerseits mit dem Mittelpunkt (M) und andererseits mit einer Anschlussklemme verbunden ist, die dazu bestimmt ist, elektrisch mit einem gemeinsamen Leiter (Cc) verbunden zu werden, mit dem das elektrische Netz (1) oder die Ausrüstung (E) ausgerüstet wurde.

2. Messorgan (O1) nach dem vorstehenden Anspruch, wobei der Messdipol (SH) eine Impedanz von kleiner als 1 kOhm aufweist, wobei der Dipol (SH) in der Lage ist, eine Spannung zu entwickeln, die zur zeitlichen Ableitung einer Gleichtaktspannung (Vᵣₑₛ), die zwischen den zwei Leistungsleitern (C1, C2) vorliegt, proportional ist.

3. Messorgan (O1) nach Anspruch 1, wobei der Messdipol (SH) eine Impedanz von größer als 1 kOhm aufweist, wobei der Dipol (SH) eine Spannung entwickelt, die zu einer Gleichtaktspannung (Vᵣₑₛ), die zwischen den zwei Leistungsleitern (C1, C2) vorliegt, proportional ist.

4. Messorgan (O1) nach einem der vorstehenden Ansprüche, wobei die kapazitiven Elemente (EC1, EC2) von einem Kondensator mit drei Anschlüssen gebildet werden, wobei ein erster Anschluss dazu bestimmt ist, elektrisch mit einem der Leistungsleiter (C1, C2) verbunden zu werden, wobei ein zweiter Anschluss dazu bestimmt ist, elektrisch mit dem anderen der Leistungsleiter (C1, C2) verbunden zu werden, und wobei der dritte Anschluss dazu bestimmt ist, mit dem gemeinsamen Leiter (Cc) verbunden zu werden.

5. Messorgan (O1) nach dem vorstehenden Anspruch, wobei der Kondensator mit drei Anschlüssen aus nur 3 Elektroden hergestellt ist.

6. Messorgan (O1) nach einem der zwei vorstehenden Ansprüche, wobei der Kondensator mit drei Anschlüssen mit Folien hergestellt ist, die gestapelt und anschließend gewickelt wurden, um einen Zylinder oder ein Parallelepiped mit drei Anschlüssen aufzubauen.

7. Messorgan (O1) nach einem der vorstehenden Ansprüche, das zusätzlich einen Widerstand mit drei Elektroden umfasst, der einen Mittelpunkt aufweist, wobei die erste Elektrode dazu bestimmt ist, elektrisch mit dem ersten Leistungsleiter (C1) verbunden zu werden, wobei die zweite Elektrode dazu bestimmt ist, elektrisch mit dem zweiten Leistungsleiter (C2) verbunden zu werden, wobei die Gleichtaktspannung (Vᵣₑₛ) zwischen dem Mittelpunkt des Widerstands mit drei Elektroden und dem gemeinsamen Leiter (Cc) vorliegt.

8. Messorgan (O1) nach einem der vorstehenden Ansprüche, das einen Stromsensor umfasst, der in der Lage ist, den in den zwei kapazitiven Elementen (EC1, EC2) fließenden Gegentaktstrom zu messen, um eine Größe zu ermitteln, die die Gleichtaktspannung (Vᵣₑₛ) darstellt, und der aus mindestens vier Luftspulen gebildet ist, die jeweils in der Nähe der kapazitiven Elemente (EC1, EC2) angeordnet sind.

9. Messorgan (O1) nach einem der vorstehenden Ansprüche, das weiter einen Stromsensor umfasst, der in der Lage ist, den in den zwei kapazitiven Elementen (EC1, EC2) fließenden Gleichtaktstrom zu messen, um eine Größe zu ermitteln, die eine Gegentaktspannung (Vₙₑₜ) darstellt.

10. Messorgan (O1) nach dem vorstehenden Anspruch, wobei der Stromsensor, der in der Lage ist, den Gleichtaktstrom zu messen, aus mindestens zwei Luftspulen gebildet ist, die jeweils in der Nähe der kapazitiven Elemente (EC1, EC2) angeordnet sind.

11. Messorgan (O1) nach einem der vorstehenden Ansprüche, das weiter einen Sensor für die Gleichstromkomponente der Gleichtaktspannung (Vᵣₑₛ) umfasst.

12. Messorgan (O1) nach einem der vorstehenden Ansprüche, das weiter einen Sensor für die Gleichstromkomponente der Gegentaktspannung (Vₙₑₜ) umfasst.

13. Vorrichtung (D) zur Erkennung einer Störung in einem elektrischen Netz (1), wobei das elektrische Netz (1) mindestens eine elektrische Ausrüstung (E) umfasst, die elektrisch mit einem ersten Leistungsleiter (C1) und einem zweiten Leistungsleiter (C2) verbunden ist, wobei das Netz auch mit einem gemeinsamen Leiter (Cc) ausgestattet ist, wobei die Vorrichtung (D) dazu bestimmt ist, mit den Leistungsleitern (C1, C2) und mit dem gemeinsamen Leiter (Cc) im Bereich einer Messzone verbunden zu werden, und umfasst:
- ein erstes Messorgan (O1) nach einem der vorstehenden Ansprüche;
- ein zweites Messorgan (O2), das es ermöglicht, eine zweite Größe (Iₙₑₜ) auszuarbeiten, die einen in den Leistungsleitern (C1, C2) fließenden Netzstrom darstellt;
- einen Rechner, der mit dem ersten und dem zweiten Messorgan verbunden ist, wobei der Rechner dazu konfiguriert ist, über einen bestimmten Beobachtungszeitraum eine Größe zu bestimmen, die eine sogenannte "gemischte" Energie (Eₘᵢₓ) darstellt, die als das Integral über den bestimmten Beobachtungszeitraum des Produkts aus der Gleichtaktspannung und dem Netzstrom bestimmt ist und in der Messzone transportiert wird, wobei die Größe, die die gemischte Energie (Eₘᵢₓ) darstellt, ausgehend von der ersten Größe (Vᵣₑₛ) und der zweiten Größe (Iₙₑₜ) bestimmt wird.

14. Erkennungsvorrichtung (D) nach dem vorstehenden Anspruch, wobei das zweite Messorgan (O2) eine Luftspule, zum Beispiel vom Rogowski-Typ, umfasst.

15. Erkennungsvorrichtung (D) nach dem vorstehenden Anspruch, wobei das zweite Messorgan (O2) auch einen Gleichstromsensor, zum Beispiel einen Neel^{®}-Effekt-Sensor, umfasst.

## Claims

1. A member (O1) for measuring a quantity representative of a common mode voltage (Vᵣₑₛ) in an electrical network (1) or in an equipment (E), the network (1) or the equipment (E) comprising at least a first power conductor (C1) and a second power conductor (C2), the measuring member (O1) comprising two capacitive elements (EC1, EC2) which are intended to be arranged in a bridge between the two power conductors (C1, C2), the two capacitive elements (EC1, EC2) being connected at a midpoint (M), the measuring member (O1) further comprising a measuring dipole (SH),
the measuring member (O1) being **characterised in that** the two capacitive elements (EC1, EC2) have a capacitance values that are identical to each other, and the measuring dipole (SH) is connected on the one hand to the midpoint (M) and on the other hand to a connection terminal intended to be electrically connected to a common conductor (Cc) of which the electrical network (1) or the equipment (E) has been equipped.

2. The measuring member (O1) according to the preceding claim wherein the measuring dipole (SH) has an impedance of less than 1kOhms, the dipole (SH) being able to develop a voltage proportional to the derivative with respect to time of a common mode voltage (Vᵣₑₛ) present between the two power conductors (C1, C2).

3. The measuring member (O1) according to claim 1 wherein the measuring dipole (SH) has an impedance greater than 1kOhms, the dipole (SH) developing a voltage proportional to a common mode voltage (Vᵣₑₛ) present between the two power conductors (C1, C2).

4. The measuring member (O1) according to any of the preceding claims wherein the capacitive elements (EC1, EC2) are formed by a three-terminal capacitor, a first terminal being intended to be electrically connected to one of the power conductors (C1, C2), a second terminal being intended to be electrically connected to the other of the power conductors (C1, C2) and the third terminal being intended to be connected to the common conductor (Cc).

5. The measuring member (O1) according to the preceding claim wherein the three terminal capacitor is made from only 3 electrodes.

6. The measuring member (O1) according to one of the two preceding claims wherein the three-terminal capacitor is made with sheets stacked and then rolled up to form a cylinder or a 3-terminal parallelepiped.

7. The measuring member (O1) according to one of the preceding claims, further comprising a three-electrode resistor having a midpoint, the first electrode being intended to be electrically connected to the first power conductor (C1), the second electrode being intended to be electrically connected to the second power conductor (C2), the common mode voltage (Vᵣₑₛ) being present between the midpoint of the three-electrode resistor and the common conductor (Cc) .

8. The measuring member (O1) according to one of the preceding claims comprising a current sensor, capable of measuring the differential mode current flowing in the two capacitive elements (EC1, EC2), in order to establish a quantity representative of the common mode voltage (Vᵣₑₛ), and formed of at least four air coils respectively arranged in the vicinity of the capacitive elements (EC1, EC2).

9. The measuring member (O1) according to one of the preceding claims, further comprising a current sensor, capable of measuring the common mode current flowing in the two capacitive elements (EC1, EC2) in order to establish a quantity representative of a differential mode voltage (Vₙₑₜ).

10. The measuring member (O1) according to the preceding claim wherein the current sensor capable of measuring the common mode current is formed by at least two air coils respectively arranged in the vicinity of the capacitive elements (EC1, EC2).

11. The measuring member (O1) according to any of the preceding claims further comprising a sensor of the DC component of the common mode voltage (Vᵣₑₛ).

12. The measuring member (O1) according to any of the preceding claims further comprising a sensor of the DC component of the differential mode voltage (Vₙₑₜ).

13. A device (D) for detecting a fault in an electrical network (1), the electrical network (1) comprising at least one electrical equipment (E) electrically connected to a first power conductor (C1) and to a second power conductor (C2), the network also being provided with a common conductor (Cc), the device (D) being intended to be connected to the power conductors (C1, C2) and to the common conductor (Cc) at a measurement area and comprising:
- a first measuring member (O1) in accordance with one of the preceding claims;
- a second measuring member (O2) for producing a second quantity (Iₙₑₜ) representative of a network current flowing through the power conductors (C1, C2);
- a calculator, connected to the first and second measuring members, the calculator being configured to determine, over a determined observation period, a quantity representative of a so-called "mixed" energy (Eₘᵢₓ) defined as the integral over the determined observation period of the product of the common mode voltage and the network current and conveyed in the measurement area, the quantity representative of the mixed energy (Eₘᵢₓ) being determined from the first quantity (Vᵣₑₛ) and from the second quantity (Iₙₑₜ)

14. The detection device (D) according to the preceding claim wherein the second measuring member (O2) comprises an air coil, for example of the Rogowski type.

15. The detection device (D) according to the preceding claim wherein the second measuring member (O2) also comprises a direct current sensor, for example a Neel Effect^{®} sensor.
